(19) Europäisches Patentamt
European Patent Office
Office européen des brevets

(11) **EP 3 380 856 B1**

(12) **EUROPÄISCHE PATENTSCHRIFT**

(45) Veröffentlichungstag und Bekanntmachung des Hinweises auf die Patenterteilung:
**23.10.2019 Patentblatt 2019/43**

(21) Anmeldenummer: **16816177.6**

(22) Anmeldetag: **21.11.2016**

(51) Int Cl.:
*G01R 33/36* *(2006.01)*          *G01R 33/60* *(2006.01)*
*G01N 24/10* *(2006.01)*

(86) Internationale Anmeldenummer:
**PCT/DE2016/100539**

(87) Internationale Veröffentlichungsnummer:
**WO 2017/088851 (01.06.2017 Gazette 2017/22)**

(54) **VORRICHTUNG ZUR ERZEUGUNG UND DETEKTION EINER MAGNETISCHEN RESONANZ EINER PROBE**

DEVICE FOR GENERATING AND DETECTING A MAGNETIC RESONANCE OF A SAMPLE

DISPOSITIF POUR GÉNÉRER ET DÉTECTER UNE RÉSONANCE MAGNÉTIQUE D'UN ÉCHANTILLON

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.11.2015 DE 102015120644**
**05.02.2016 DE 102016102025**

(43) Veröffentlichungstag der Anmeldung:
**03.10.2018 Patentblatt 2018/40**

(73) Patentinhaber: **Helmholtz-Zentrum Berlin für Materialien**
**und Energie GmbH**
**14109 Berlin (DE)**

(72) Erfinder:
• **ANDERS, Jens**
**89081 Ulm (DE)**
• **LIPS, Klaus**
**10781 Berlin (DE)**
• **ORTMANNS, Maurits**
**89075 Ulm (DE)**

(56) Entgegenhaltungen:
• **T. YALCIN ET AL: "Single-chip detector for electron spin resonance spectroscopy", REVIEW OF SCIENTIFIC INSTRUMENTS., Bd. 79, Nr. 9, 30. September 2008 (2008-09-30), Seite 094105, XP055353521, US ISSN: 0034-6748, DOI: 10.1063/1.2969657 in der Anmeldung erwähnt**
• **MAFFEZZONI PAOLO ET AL: "Analysis and Design of Weakly Coupled LC Oscillator Arrays Based on Phase-Domain Macromodels", IEEE TRANSACTIONS ON COMPUTER AIDED DESIGN OF INTEGRATED CIRCUITS AND SYSTEMS, IEEE SERVICE CENTER, PISCATAWAY, NJ, US, Bd. 34, Nr. 1, 27. Oktober 2014 (2014-10-27), Seiten 77-85, XP011567926, ISSN: 0278-0070, DOI: 10.1109/TCAD.2014.2365360 [gefunden am 2014-12-17]**
• **JENS ANDERS ET AL: "K-band single-chip electron spin resonance detector", JOURNAL OF MAGNETIC RESONANCE., Bd. 217, 18. Februar 2012 (2012-02-18), Seiten 19-26, XP055354363, US ISSN: 1090-7807, DOI: 10.1016/j.jmr.2012.02.003**

**Beschreibung**

Technisches Gebiet

Die Erfindung betrifft eine Vorrichtung zur Erzeugung und Detektion einer magnetischen Resonanz einer Probe, wie sie zum Beispiel in der Elektronenspinresonanz-Spektroskopie und der Kernspinresonanzspektroskopie zur Anwendung kommt, die unter anderem in der Experimentalphysik, der Chemie, der Medizintechnik oder den Geowissenschaften Einsatz finden.

Stand der Technik

Bei der Elektronenspinresonanz-Spektroskopie (ESR, electron spin resonance spectroscopy auch als EPR, electron paramagnetic resonance bezeichnet) und der Kernspinresonanzspektroskopie (NMR, nuclear magnetic resonance spectroscopy) werden Proben in einem statisch homogenen, statisch inhomogenen oder dynamischen (gepulst inhomogenen) Magnetfeld, üblicherweise als $B_0$ bezeichnet, zusätzlichen hochfrequenten, elektromagnetischen Wechselfeldern (in der ESR zumeist im Mikrowellenbereich zwischen 1 und 263 GHz), üblicherweise als $B_1$ bezeichnet, ausgesetzt.

Durch die Einkopplung von Wechselfeldern ($B_1$) geeigneter Frequenz und Polarisation werden Übergänge zwischen den Energieniveaus diskreter Spinzustände der Atomkern- und/oder Elektronenkonfiguration einer Probe induziert, die ihrerseits zu Absorptionsvorgängen im Wechselfeld führen, welche sich detektieren lassen. Aus den detektierten Absorptionsvorgängen lassen sich verschiedene stoffanalytische Informationen der Probe bestimmen. Das linear polarisierte Feld $B_1$ ist dabei üblicherweise senkrecht zu $B_0$ orientiert.

Proben, die einer Charakterisierung durch ESR- oder NMR- Experimente zugänglich sind, sind demnach alle magnetisierbaren Proben, d.h. paramagnetische Proben (ungepaarte Elektronen, ESR) oder Proben mit Atomkernen mit "Nettokernspin" aufgrund ungerader Anzahl an Nukleonen (NMR). Die Proben können sowohl flüssig, fest oder auch gasförmig sein. Im Folgenden ist der Begriff "Probe" immer verwendet im Sinne einer magnetisierbaren Probe, wie vorstehend eingeführt.

Zur eindeutigen Charakterisierung der Energiedifferenzen der Spinzustände (Resonanzenergie) und der zugehörigen Spektrallinien, den spektralen Komponenten, kann wahlweise das gyromagnetische Verhältnis $\gamma$ oder der sogenannte $g$-Faktor, auch Landé-Faktor genannt, gemäß

$\Delta E = h \cdot \omega = \gamma \cdot B_0 \cdot h = g \cdot \mu_B \cdot B_0$ ($h$ = Plancksches Wirkungsquantum, $\mu_B$ = Bohrsches Magneton, $\omega$ = Kreisfrequenz der Präzession des Magnetfeldes), benutzt werden. Die $g$-Faktoren sind dabei nicht unbedingt isotrop und müssen gegebenenfalls als Tensoren behandelt werden. Die spektralen Komponenten hängen dabei nicht nur von den $g$-Faktoren ab, sondern z.B. auch von der Kopplung mit benachbarten Kernspins und Elektronenspins. Dabei kann z.B. durch mikroskopische magnetische Wechselwirkungen innerhalb der Probe die Energiedifferenz von Spinzuständen weiter modifiziert sein, was sich dann durch den sogenannten vollständigen Hamilton-Wechselwirkungsoperator beschreiben lässt. Im Folgenden wird dieser komplexe Zusammenhang einfach mit dem Resonanzfall der zu betrachtenden Spinzustände umschrieben, die jeweiligen Wechselwirkungen werden nicht weiter erläutert. Im Resonanzfall entspricht die Frequenz der sogenannten Lamorfrequenz.

Im Resonanzfall der Anregung durch das $B_1$-Feld treten sogenannte Rabi-Oszillationen auf. Dies sind Oszillationen in einem quantenmechanischen Zwei- oder Mehrniveau-System, welches mit einer externen periodischen Kraft (z. B. ein oszillierendes Magnetfeld) wechselwirkt. Liegt die Anregungsfrequenz nahe der Resonanzfrequenz der Übergänge, so oszilliert die Besetzung der Zustände mit einer Frequenz, die auch als Rabi-Frequenz bezeichnet wird.

ESR- als auch NMR-Experimente werden üblicherweise bei der bzw. möglichst nahe der Resonanzfrequenz durchgeführt, wie es auch im Folgenden, wenn nicht anders vermerkt, vorausgesetzt wird.

In den sogenannten "Dauerstrich"- (englisch: continuous wave) ESR- oder NMR-Experimenten wird bei kontinuierlicher Einstrahlung von magnetischen Wechselfeldern ($B_1$) und eventueller gleichzeitiger Änderung der Stärke des Magnetfeldes ($B_0$) die Energie bestimmt, die erlaubten oder schwach verbotenen Übergängen zwischen verschiedenen Energieniveaus von Spinensembles entspricht (Resonanzfall).

In sogenannten gepulsten ESR- oder NMR-Experimenten wird mit einem starken elektromagnetischen Puls ($B_1$) (transientes Magnetfeld) eine Präzessionsbewegung der Orientierung der makroskopischen Magnetisierung der Probe um die Richtung des effektiven Magnetfelds in der Probe angeregt und ihr Relaxationsprozess sowie die Präzessionsfrequenz detektiert, bei statischem oder auch dynamischem (zeitlich und oder örtlich veränderlichem) Magnetfeld $B_0$. Der Relaxationsprozess wird auch als transiente (zeitlich veränderliche) Magnetisierung bezeichnet bzw. ein sogenanntes transientes Signal wird detektiert. Die transiente Magnetisierung ist in ihrer zeitlichen Dauer begrenzt durch die Spin-Gitter-Relaxationszeit ($T_1$) und die Spin-Spin-Relaxationszeit ($T_2$). Für ESR-Experimente liegen diese Zeiten im Sub-Nano- bis Sekundenbereich, die üblichen Messfenster liegen aber zwischen 1 ns bis 1 ms.

Zur Vermeidung von Relaxationsprozessen während der Anregung, wodurch die Modellierung des Experiments deutlich vereinfacht wird, muss die Zeitspanne, in der das transiente Magnetfeld ($B_1(t,\omega)$) anliegt, kurz gegenüber den Relaxationszeiten sein. Da Relaxationszeiten einer Probe im ESR-Fall im Sub-Nanosekundenbereich liegen können, sind transiente Magnetfelder mit Zeitdauern im Sub-Nanosekundenbereich (< 1 ns) für bestimmte Proben erforderlich. Die Zeitdauer der transienten Magnetisierung ist dabei über den Zusammenhang zur Spin-Gitter-Relaxationszeit ($T_1$) und Spin-Spin-Relaxationszeit ($T_2$) abhängig von der Probe.

Das Magnetfeld $B_0$ kann bei gepulsten ESR- oder NMR-Experimenten ein über den Ort linear veränderliches Magnetfeld (Gradientenfeld) sein, wie es z.B. in bildgebenden Verfahren, die auf Magnetresonanz beruhen, eingesetzt wird.

Die physikalischen Grundlagen werden im Folgenden näher ausgeführt.

In der klassischen Mechanik erfährt ein magnetisches Dipolmoment $\vec{\mu}$ in einem magnetischen Feld $\vec{B}$, ein Drehmoment $\vec{\tau}$ gemäß $\vec{\tau} = \vec{\mu} \times \vec{B}$ Demgemäß kann im Prinzip jedwede makroskopische Magnetisierung $\vec{M}$ in Form eines angelegten, äußeren Magnetfeldes beeinflusst werden, weil sie aus einem kombinierten Effekt mikroskopischer magnetischer Momente resultiert. ESR- oder NMR-Experimente sind hierfür bekannte Beispiele, in denen ein externes Magnetfeld angelegt wird und eine Probenmagnetisierung $\vec{M}_s$, die geknüpft ist an die Spins von Elektronen bzw. Atomkernen und deren Wechselwirkung, bestimmt wird. Quantenmechanische Betrachtungen zeigen, dass der Spin eines Teilchens nicht nur geknüpft ist an das magnetische Dipolmoment $\vec{\mu}$, sondern auch an den Bahndrehimpuls $\vec{L}$, welche miteinander in Beziehung stehen gemäß

$\vec{\mu} = \gamma \cdot \vec{L}$ mit dem gyromagnetischen Verhältnis $\gamma$, welches spezifisch ist für ein Material einer Probe. Im einfachsten zu betrachtenden Fall von Spin ½ Teilchen und der Annahme, dass keine Interaktion zwischen den Spins vorliegt, kann die makroskopische Magnetisierung, die auf den Spins basiert, innerhalb eines angelegten magnetischen Feldes $\vec{B}$, beschrieben werden mit einer vereinfachten Bloch-Gleichung, d.h. einer Bloch-Funktion ohne Relaxationsterme gemäß

$$\frac{d\vec{M}_s}{dt} = -\gamma \cdot \left( \vec{M}_s \times \vec{B} \right). \tag{0.1}$$

Aus (0.1) folgt, dass eine spinbasierte Magnetisierung $M_s$, welche einen Winkel einschließt mit einem magnetischen Feld $B_0$, eine Präzessionsbewegung um die Achse des $B_0$-Feldes ausführt, mit einer Winkelgeschwindigkeit, die der sogenannten Larmorfrequenz $\omega_L = -\gamma \cdot B_0$ entspricht. Eine Auslenkung der Magnetisierung $M_s$ kann z.B. durch ein angelegtes, zeitlich veränderliches Magnetfeld $B_1$, welches senkrecht zu $B_0$ orientiert ist und eine Frequenz $\omega_L$ aufweist, erfolgen, so dass $M_s$ um die Achse des $B_1$-Feldes rotiert. Da dieser Fall, in dem $\vec{M}_s$ nicht parallel zu $\vec{B}_0$ orientiert ist, einem Ungleichgewichtszustand entspricht, bewirken Relaxationsmechanismen, dass jegliche transversale Magnetisierung $M_{s\perp}$ zu Null abklingt und die longitudinale Magnetisierung $M_{s\parallel}$ in der Richtung von $B_0$ wiederhergestellt wird, was dem Gleichgewichtszustand $M_{s0}$ entspricht. Diesem Umstand kann mit der Einführung der Relaxationszeiten in die Bloch-Gleichung gemäß (0.1) Rechnung getragen werden mit

$$\frac{d\vec{M}_s}{dt} = -\gamma \cdot \left( \vec{M}_s \times \vec{B} \right) + \frac{1}{T_2} \cdot \vec{M}_{s\perp} + \frac{M_{s\parallel} - M_{s0}}{T_1} \vec{e}_{\parallel} \tag{0.2}$$

($t$ = Zeit, $\vec{e}_{\parallel}$ = Einheitsvektor in Richtung des $B_0$-Feldes).

In dem **Aufsatz 1** von M. Prisner et al. (Pulsed EPR Spectroscopy: Biological Applications, Annual Review of Physical Chemistry 52, 2001, S. 279-313) ist eine Übersicht über gepulste ESR-Experimente an biologischen Proben gegeben und in dem **Aufsatz 2** von R. Benn und H. Günther (Modern Pulse Methods in High-Resolution NMR Spectroscopy, Angewandte Chemie International Edition, Vol. 22, 1983, S. 350 - 380) über gepulste NMR-Experimente.

In der DE 42 23 909 C2 ist eine Vorrichtung zum Messen magnetischer Resonanz zum Einsatz in der Medizintechnik offenbart, in der eine Solenoid-Spule zur Erzeugung des Magnetfeldes $B_0$ dient. Eine als Sende- oder Empfangseinrichtung genutzte Anordnung besteht aus einem Spaltringresonator. Weiterhin ist eine Koppeleinrichtung zur Detektion eines Resonanzsignals vorgesehen, realisiert durch eine Koppelschleife. Weitere Schaltungseinheiten vervollständigen die Vorrichtung.

Eine als Elektronenspinresonanz-Impulsspektrometer bezeichnete Vorrichtung ist in der DE 44 12 064 A1 offenbart. Sie verfügt über einen ersten Mikrowellenoszillator zum Erzeugen von Abtastsignalen (Messsignalen) $B_1$, und einem zweiten Mikrowellenoszillator zum Erzeugen von Hilfssignalen einer niedrigeren Mikrowellenfrequenz. Zusätzlich sind ein erster Mischer und ein Pulsformkanal zur Erzeugung von Mischsignalen mit einer für Elektronenspinresonanz-Impulsexperimenten geeigneten Pulslänge und ein Resonator zur Detektion vorgesehen.

In der US 2014/0210473 A1 ist ein Elektronenspinresonanz-Spektrometer offenbart, das mit einer Tastspitze als Sende- und Empfangsvorrichtung ausgestattet ist. Dabei wird das Anregungsfeld ($B_1$) für die Sendevorrichtung außerhalb von dieser erzeugt und mit geeigneten Mitteln in die Tastspitze geleitet. Das Spektrometer kann auch im gepulsten Modus betrieben werden, wobei die Pulse und die Erfassung der Signale von einer zeitlichen Dauer sind, die jedoch keine zeitaufgelöste Erfassung einer transienten Magnetisierung einer Probe ermöglichen.

In dem **Aufsatz 3** von T. Yalcin und G. Boero (Single-chip detector for electron spin resonance spectroscopy, Review of Scientific Instruments 79, 2008, S. 094105-1 - 6) wird eine Methode offenbart, mittels derer LC-Oszillatoren für Dauerstrich ESR-Experimente verwendbar sind. Die Methode basiert auf der Grundlage, dass der Strom, der durch die Spule des LC-Oszillators fließt, ein kontinuierliches (Dauerstrich) Mikrowellen-Magnetfeld ($B_1$) erzeugt, dem eine Probe ausgesetzt ist. Dieses Feld ($B_1$) beeinflusst die Magnetisierung der Probe, was wiederum im LC-Oszillator als eine Änderung der Frequenz detektiert werden kann. Das $B$-Feld und die magnetische Feldstärke $H_1$ innerhalb einer linearen Probe sind bei genügend (probenabhängig) niedrigen Frequenzen des $B_1$-Feldes proportional zu einander. Dies entspricht einer reellwertigen relativen Permeabilität $\mu_r$ und der Suszeptibilität der Probe $\chi_m$, deren Zusammenhang $\mu_r$ = 1 + $\chi_m$ ist. Bei höheren Frequenzen des $B_1$-Feldes kann es zu einer Zeitverschiebung zwischen dem $B_1$-Feld und der Feldstärke $H_1$ kommen. Diese Zeitverschiebung kann für den Sonderfall sinusförmiger Zeitverläufe als komplexe Permeabilität und Suszeptibilität der Probe abgebildet werden, gemäß $\underline{\mu_r = \mu_r' - j \cdot \mu_r''}$ und $\underline{\chi_m = \chi_m' - j \cdot \chi_m''}.$

Die komplexe Permeabilität und Suszeptibilität wird zum Beispiel in dem **Aufsatz 4** von N. Bloembergen und R.V. Pound (Radiation Damping in Magnetic Resonance Experiments, Physical Reviews, Vol 95(1), 1954, S. 8-12) näher beschrieben. Der Zusammenhang zwischen dem statischem Magnetfeld $B_0$, dem Mikrowellenfeld $B_1$ und der Magnetisierung der Probe $M_s$ ist eingeführt unter Berücksichtigung einer komplexen Magnetisierung der Probe, welche die Mikrowellen-Feldstärke $H_1$ , gemäß $H_1 = B_1/\mu_0$ ($\mu_0$ = magnetische Feldkonstante), mit der stationären Magnetisierung eines Spinensembles $M_x$ unter Dauerstrichanregung verbindet, als $M_x = (\chi' \cdot \cos(\omega_{osc0} \cdot t) + \chi'' \cdot \sin((\omega_{osc0} \cdot t)) \cdot 2H_1$, wobei $\omega_{osc0}$ die Frequenz der magnetischen Feldstärke $H_1$, die freie Oszillationsfrequenz, ist und $t$ die Zeit. Die freie Oszillationsfrequenz des Oszillators muss unter anregenden Bedingungen der Lamorfrequenz entsprechen bzw. nahe dieser sein. Die Änderung in der Oszillationsfrequenz, unter dem Einfluss der magnetisierten Probe, gegenüber der freien Oszillationsfrequenz entspricht für ausreichend kleine Spinensembles (d.h. nicht lineare Effekte sind vernachlässigbar), dem Term

$$\Delta\omega_{osc,\chi} = \tfrac{1}{2} \omega_{osc0}\eta\chi', \qquad\qquad (0.3)$$

mit $\eta$ = Füllfaktor. Der Term resultiert aus einer Taylorreihennäherung 1. Ordnung, wobei die höheren Ordnungen unter geringem Verlust an Genauigkeit vernachlässigbar sind.

Eine Herausforderung für ESR- oder NMR-Experimente ist die Realisierung als sogenannte "single chip" (Einchipprozessor) Ausführungen mit integrierter Schaltungstechnik, die die Anwendung der Experimente im Vergleich zu herkömmlichen Ausführungen nutzerfreundlich, in Miniaturisierung, kostengünstig und energieeffizient gestalten.

Miniaturisierte Detektoren in EPR- bzw. NMR-Vorrichtungen verbessern deren Nachweisgrenze bezüglich der benötigten Anzahl Spins in einem vom Detektor erfassten Volumen, mit der eine Magnetisierung zuverlässig zu detektieren ist, d.h. die Spinsensitivität ist verbessert. Die Spinsensitivität skaliert dabei proportional zum Durchmesser der Spule / des Detektors. Eine isotrope Skalierung (bei gleichem $B_0$-Feld und bei gleicher Temperatur) um drei Größenordnungen bringt eine Steigerung von zwei Größenordnungen. Die Spinsensitivitäten bewegen sich dabei in Größenordnungen von ca. $10^{11} spins/G \cdot \sqrt{Hz}$ für Volumenresonatoren mit einigen zehn bis hundert Mikrolitern aktivem Volumen und von ca. $10^8 spins/G \cdot \sqrt{Hz}$ für miniaturisierte Spulen mit ca. einem Nanoliter aktivem Volumen, was eine Verbesserung von einigen Größenordnungen der miniaturisierten Spulen gegenüber den Volumenspulen bedeutet. Eine zu starke Miniaturisierung bringt hingegen gleichzeitig den Nachteil mit sich, dass das Messergebnis nicht valide ist für eine zuverlässige Bestimmung einer geringen Konzentration an Spins bzw. einer Magnetisierung für ein größeres Volumen in einer Probe oder einer Probe in ihrer Gesamtheit, d.h. die Konzentrationssensitivität geht verloren. Dabei liegt die Konzentrationssensitivität einer Spule mit 100 μm Durchmesser (~ 100 pl empfindliches Volumen) bei ca. 1 mmol/l bis zu einigen 100 mmol/l.

Ein Ansatz die Vorteile der Miniaturisierung zu nutzen und gleichzeitig die Nachteile des Verlustes eines Nachweises im Volumen auszugleichen ist in dem **Aufsatz 5** von J. Anders et al. (A single-chip array of NMR receivers, Journal of Magnetic Resonance 201, 2009, S. 239- 249) offenbart. Die vorgestellte Vorrichtung umfasst eine Anordnung von acht separaten Kanälen, die jeweils aus einer Erfassungsspule, einem Abstimmkondensator, einem rauscharmen Verstärker und einem 50 $\Omega$-Trennverstärker bestehen. Jede Erfassungsspule hat einen Durchmesser von 500 $\mu$m, woraus eine aktive (Detektor-)Fläche von 1 mm x 2 mm resultiert. Nachteilig an dieser Vorrichtung ist, dass die Anregung der Spins in der Probe nicht integriert (pro Spule) erfolgt. Pro Spule ist außerdem eine komplette Empfangsvorrichtung (bestehend aus mindestens: rauscharmer Vorverstärker, Mischer, weiterer Verstärker, ADC-Umsetzer) erforderlich, wodurch die Vorrichtung aufwendig wird.

Als Miniaturisierung ist hierbei allgemein aufzufassen, was in integrierter Schaltungstechnik, wie z.B. CMOS (Complementary metal-oxide-semiconductor, komplementäre Metall-Oxid-Halbleiteter), ausgeführt ist bzw. in deren Größenordnungen und kleiner.

Ein weiterer Nachteil vieler aus dem Stand der Technik bekannten Vorrichtungen für ESR- und NMR-Messungen sind deren hohe Energieverbräuche. Diese resultieren daraus, dass die Systeme, mit Ausnahme weniger, in integrierter Schaltungstechnik realisierter, miniaturisierter Vorrichtungen, für eine 50 $\Omega$-Umgebung ausgelegt sind, wodurch relativ hohe Leistungen zur Generierung des zusätzlichen Wechselfeldes ($B_1$) resultieren. Eine weitere Vereinfachung der bisher vorgeschlagenen Systeme ist zudem anzustreben, um diese kostengünstiger und platzsparender ausführen zu können.

Aufgabenstellung

Die Aufgabe der vorliegenden Erfindung ist es, eine Vorrichtung zur Erzeugung und Detektion einer magnetischen Resonanz einer Probe anzugeben, die eine, im Vergleich zum Stand der Technik, hohe Spinsensitivität aufweist bei gleichzeitiger, im Vergleich zum Stand der Technik, hoher Konzentrationssensitivität und zusätzlich vereinfacht und energiesparend aufgebaut ist.

Die Aufgabe wird durch die Vorrichtung des Anspruchs 1 gelöst. Vorteilhafte Ausführungen sind Gegenstand der Unteransprüche.

Das Mittel zur Erzeugung eines Magnetfelds vorbestimmter Richtung in der erfindungsgemäßen Vorrichtung ist zum Beispiel durch supraleitende Magnete oder Elektromagnete beliebiger Ausführung oder Permanentmagnete realisiert. Das erzeugte Magnetfeld ist statisch und entspricht dem Magnetfeld $B_0$, das zur Magnetisierung einer zur Magnetisierung geeigneten Probe dient. Das Magnetfeld kann dabei von beliebiger Stärke sein, solange die Frequenz des anregenden $B_1$-Magnetfelds entsprechend den Resonanzbedingungen gewählt wird.

Als Proben kommen feste, gasförmige und flüssige Proben in Betracht. Flüssige Proben können z.B. in Glaskapillaren auf planare Ausführungen (z.B. in CMOS-Technologie) gelegt werden. Bei niedrigeren Frequenzen von $B_1$ bis in das sogenannte X-Band (ca. 10 GHz) können die Spulen der LC-Oszillatoren auch als Volumenspulen realisiert werden, in die die Kapillaren mit flüssigen Proben eingebracht werden können, oder aber mit (mikro-)fluidischen Systemen zum Transport von Proben in den Detektor kombiniert werden. Alternativ kann auch die Vorrichtung in die zu messende Flüssigkeit, das Gas oder den Festkörper getaucht bzw. eingebracht werden oder auf andere Art mit ihr verknüpft sein, wie z.B. über Sprühen. Phasenübergänge und Änderungen (Übergänge) von Aggregatzuständen sind so erfassbar,

Der Probenort ist ein Ort in der Vorrichtung, an dem die Probe angeordnet wird und an dem sowohl das Magnetfeld ($B_0$) als auch, gegebenenfalls, das transiente Magnetfeld ($B_1$) anliegen. Es können hier Mittel zur Befestigung und Aufbewahrung der Probe vorgesehen sein.

Eine Anordnung von mindestens zwei LC-Oszillatoren bildet entweder die Empfangsvorrichtung oder die Sendevorrichtung, jeweils als alleinige Funktion, oder auch simultan die Sende- und Empfangsvorrichtung (das bedeutet eine Vorrichtung, die beide Funktionen erfüllt).

Im Falle, dass die Anordnung nur die Empfangsvorrichtung bildet, wird die Sendevorrichtung aus Mitteln, die aus dem Stand der Technik bekannt sind, wie z.B. Spulen, Leitungsstreifen, Resonatoren oder Antennen gebildet.

Im Falle, dass die Anordnung nur die Sendevorrichtung bildet, wird die Empfangsvorrichtung aus Mitteln, die aus dem Stand der Technik bekannt sind, wie z.B. Resonatoren, Antennen, Spulen oder Leitungsstreifen gebildet.

Im Falle, dass die Anordnung simultan sowohl die Sendevorrichtung als auch die Empfangsvorrichtung bildet, werden keine weiteren Mittel als Sendevorrichtung zur Manipulation einer Magnetisierung einer Probe (zusätzlich zum Magnetfeld $B_0$) und als Empfangsvorrichtung zur Detektion einer Magnetisierung einer Probe benötigt.

Vorteilhaft ist insbesondere die Ausführung, in der Sendevorrichtung und Empfangsvorrichtung beide durch eine gemeinsame Anordnung verwirklicht sind, da sie einen besonders vereinfachten, kosten- und platzsparenden Aufbau ermöglicht.

Jeder LC-Oszillator der Anordnung übernimmt dabei in allen drei vorgenannten Fällen jeweils eine der drei Funktionen, Empfangs-, Sende- oder Kombination von Sende- und Empfangsvorrichtung, entsprechend der Nutzung der Anordnung.

Die LC-Oszillatoren sind so ausgelegt, dass ihre Oszillationsfrequenz vom Wert eines induktiven Elements der LC-Oszillatoren abhängt. LC-Oszillatoren, die diese Forderung erfüllen, sind z. B. Hartley-, Colpitts- oder Armstrong-Oszillatoren oder LC-Tank-Oszillatoren. Die LC-Oszillatoren können dabei sowohl als LC-Oszillatoren mit fester Arbeitsfrequenz ausgeführt werden als auch durch die Verwendung von abstimmbaren (elektrisch oder mechanisch) Induktivitäten und/oder Kapazitäten für ein ganzes Frequenzband entworfen sein.

Die Anordnung der LC-Oszillatoren ist dabei erfindungsgemäß so gewählt, dass sich die Probe bzw. der Probenort im Nahfeld der LC-Oszillatoren befindet.

Das Nahfeld ist hier für die erfindungsgemäße Vorrichtung als das Feld des LC-Oszillators aufzufassen, in dem die Rotation des $B_1$-Feldes und wegen div $B = 0$ auch das gesamte $B_1$-Feld maßgeblich über die Stromdichte $J$ im induktiven Element bestimmt ist mit rot $\vec{B} \approx \mu_0 \cdot \vec{j}$ ($\mu_0$ = magnetische Feldkonstante). Im Gegensatz dazu findet im Fernfeld eine Wellenausbreitung statt und das $B_1$- und $E_1$-Feld (elektrische Feld) erzeugen sich gegenseitig mit rot $\vec{B_1} \approx \mu_0 \cdot \epsilon_0 \partial \vec{E_1}/\partial t$, wobei $\epsilon_0$ = elektrische Feldkonstante, $t$ = Zeit. Für das Nahfeld gilt mithin, dass das $B_1$-Feld weitestgehend unabhängig vom $E_1$-Feld erzeugt werden kann, da im Bereich des Nahfelds noch keine Welle vorliegt. Durch diesen Umstand ist das $E_1$-Feld optimierbar bzw. kann dieses gering gehalten werden. Geringe $E_1$-Felder minimieren elektrische Verluste in der Probe sowie den Verlust der durch die Erwärmung der Probe entsteht, was ein Vorteil der erfindungsgemäßen Vorrichtung ist.

Die räumliche Gestaltung der Anordnung der LC-Oszillatoren ist bei einer Anzahl von mehr als zwei LC-Oszillatoren als flächenhaftes Verbundsystem von einzelnen LC-Oszillatoren, bevorzugt in Reihen und Spalten, ausgeführt (aus dem Englischen entlehnt auch als "Array" bezeichnet). Eine beliebige Anordnung der LC-Oszillatoren zueinander ist auch ausführbar. Der Sonderfall einer einzelnen Reihe oder Kette ist hier mit inbegriffen. Die Charakterisierung als "flächenhaft" umfasst dabei neben einer ebenen Ausführung auch beliebig gekrümmte Flächen mit und ohne Rand (z. B. Zylinderoberfläche, Kegeloberfläche, Sphäre).

In Abhängigkeit vom Grad der Miniaturisierung, die mindestens bis zu Größen von 20 $\mu$m für die einzelnen LC-Oszillatoren realisierbar ist, wird eine hohe Spinsensitivität erzielt. Durch die Anordnung mehrerer LC-Oszillatoren, die frequenzsynchronisiert sind, ist eine hohe Konzentrationssensitivität in Abhängigkeit von der Anzahl der LC-Oszillatoren realisierbar, da dadurch die aktive Fläche der Empfangsvorrichtung vergrößert wird. Durch die Frequenzsynchronisation (Frequenzverriegelung) der LC-Oszillatoren in der Anordnung ist gewährleistet, dass eine zusammenwirkende, homogene Manipulation einer Magnetisierung einer Probe bewirkt wird und eine zusammenwirkende Detektion mit einer gemeinsamen Auslesung der Oszillationsfrequenz der Anordnung zur Bestimmung einer Änderung einer Magnetisierung einer Probe (verursacht durch die Manipulation) als Summe aller LC-Oszillatoren der Anordnung und somit der aktiven Fläche erfolgt.

Der erreichbare Grad der Miniaturisierung einzelner LC-Oszillatoren hängt dabei von der Fertigungstechnik und der Wahl der Ausführung der Spulen ab. Mögliche Ausführungen der Spulen neben den bekannten Spulen in LC-Oszillatoren sind z.B. Spulen aus supraleitendem Material oder in Form einer Streifenleitung (z.B. auch Nanodrähte), wobei Größenordnungen im Nanometerbereich erreichbar sind. Theoretisch ist auch eine Ausführung der Spulen auf atomarer bzw. molekularer Ebene denkbar.

Mit Frequenzsynchronisation (Frequenzverriegelung, engl. frequency locking) ist hier gemeint, dass die LC-Oszillatoren durch schaltungstechnische Mittel erzwungen die gleiche freie Oszillationsfrequenz aufweisen.

Die Frequenzsynchronisation der LC-Oszillatoren ist realisiert durch eine Verschaltung als Koppelnetzwerk. "Verschaltet durch ein Koppelnetzwerk" bedeutet, dass das Oszillationssignal eines Oszillators durch passive oder aber auch aktive Schaltungselemente in einen oder mehrere andere Oszillatoren des Arrays eingespeist wird. Der Effekt hiervon ist, dass die Ausgangssignale aller Oszillatoren mit der gleichen Frequenz schwingen. Die Phase der Oszillationssignale hängt dabei vom Koppelnetzwerk ab. Dies birgt den Vorteil, dass hierdurch die Oszillatoren in ihrer Frequenz synchronisiert werden und durch geeignete Wahl des Koppelnetzwerks auch eine unter Umständen gewünschte festgelegte Phasenverschiebung zwischen den Oszillationssignalen der Oszillatoren einstellbar ist. Je nach Art des Koppelnetzwerks sinkt das Phasenrauschen gegenüber dem Phasenrauschen eines Einzeloszillators dadurch. Bei passiven Koppelnetzwerken ist der Leistungsverbrauch gegenüber aktiven Netzwerken geringer.

Die Frequenzsynchronisation der LC-Oszillatoren ist in einer anderen Ausführungsform realisiert durch eine Netzwerkverschaltung, wobei jeder LC-Oszillator über einen zusätzlichen Eingang verfügt und eine Ausgangsspannung, mindestens eines weiteren LC-Oszillators, in den zusätzlichen Eingang eingespeist wird, wobei die LC-Oszillatoren mindestens jeweils zweiseitig miteinander verschaltet sind. Der Effekt hiervon ist ebenfalls, dass die Ausgangssignale aller Oszillatoren mit der gleichen Frequenz schwingen. Die Phase ist ebenfalls vom Koppelnetzwerk abhängig. Dies birgt auch hier den Vorteil, dass hierdurch die Oszillatoren in ihrer Frequenz synchronisiert werden und durch geeignete Wahl der Netzwerkverschaltung auch eine unter Umständen gewünschte festgelegte Phasenverschiebung zwischen den Oszillationssignalen der Oszillatoren einstellbar ist. Da es sich in erster Näherung um ein unidirektionales Netzwerk handelt, ist der Aufbau einfacher als bei passiven Koppelnetzwerken.

Die Ausführung der LC-Oszillatoren ist in einer nächsten Ausführungsform durch LC-VCOs (Voltage Controlled Oscillator, Spannungsgesteuerter Oszillator) realisiert. Die Verwendung von LC-VCOs ermöglicht ein unabhängiges Einstellen von Frequenz und Amplitude des Oszillators und somit Frequenz und Amplitude des $B_1$-Feldes, was für eine Optimierung der experimentellen Bedingungen vorteilhaft ist. Das unabhängige Einstellen von Frequenz und Amplitude erfolgt durch Kenntnis der residuellen Kopplung, die durch einmalige Messung des entsprechenden Hintergrundsignals bestimmt und dann entsprechend abgezogen wird bzw. durch entsprechende Kompensation während der Messung.

Die Schaltungsanordnung der einzelnen LC-VCOs ist bevorzugt wie folgt ausgeführt. Eine differentielle Kapazitätsdiode (Varaktor) und eine differentielle Induktivität dienen zur Bildung des LC-Schwingkreises. Zwei kreuzgekoppelte Transistoren gewährleisten eine stabile Oszillation im differentiellen Output (d.h. der Ausgangsspannung) durch negativen Widerstand und Nichtlinearität, zwischen zwei Knotenpunkten. Die Abstimmungseigenschaften werden durch die differentielle Kapazitätsdiode gewährleistet. Eine zeitabhängige Variation der Oszillationsamplitude wird z.B. umgesetzt durch eine Manipulation der Spannungsversorgung des LC-VCO. Diese einfache Ausführung eines LC-VCO gewährleistet eine geringe Leistungsaufnahme, geringen Platzbedarf und arbeitet zudem auch bei niedrigen (bis zu kryogenischen) Temperaturen.

Die Änderungen in der Oszillationsfrequenz der Anordnung von LC-Oszillatoren werden mit einer der Anordnung von LC-Oszillatoren nachgeschalteten Demodulation erfasst. Die Demodulation erfolgt mit einem Frequenzdemodulator. Eine Umwandlung der Analogsignale in Digitalsignale erfolgt in Abhängigkeit der gewählten Wandler bzw. Demodulatoren vor oder nach der Wandlung bzw. Demodulation mit entsprechenden Mitteln.

Änderungen in der Oszillationsamplitude werden mit der Anordnung von LC-Oszillatoren nachgeschalteten Mitteln erfasst. Die Amplitude der einzelnen LC-Oszillatoren in der Anordnung ist nicht durch die Kopplung synchronisiert. Daher ist jeweils an jedem einzelnen LC-Oszillator ein Signal abgreifbar, das der Magnetisierung der Probe im sensitiven Volumen dieses LC-Oszillators entspricht. Dadurch sind zusätzlich Signale erhältlich, die eine örtliche Auflösung erlauben. Zu berücksichtigen ist dabei, dass die Amplituden der LC-Oszillatoren einer Kopplung innerhalb des LC-Oszillators unterliegen, auf die die Signale korrigiert werden müssen. Das amplitudenmodulierte Signal kann mit einfachen Mitteln an den einzelnen LC-Oszillatoren abgegriffen werden. Dazu bedarf es lediglich für jeden LC-Oszillator eines Verstärkers für das Signal (bei Dauerstrich-Experimenten in der Regel kHz-Bereich), welches durch die intrinsische Demodulation, die bei Verwendung einer Stromquelle für die Versorgung der LC-Oszillators direkt im Basisband verfügbar ist und an Knoten in den LC-Oszillatoren abgegriffen wird. Das Signal muss dabei nicht von der Larmorfrequenz abwärtsgemischt werden. Neben der Komplexität der Schaltung wird dadurch auch der Leistungsverbrauch optimiert.

Eine Umwandlung der Analogsignale in Digitalsignale erfolgt in Abhängigkeit der gewählten Wandler bzw. Demodulatoren vor oder nach der Wandlung bzw. Demodulation.

Das Mittel zur Bestimmung spektraler Komponenten der Probe, das auf dem Mittel zur digitalen Datenverarbeitung bereitgestellt ist, realisiert im Dauerstrichmodus eine Bestimmung spektraler Komponenten, die dem Term (0.3) entspricht.

Die Nutzung der Anordnung im Dauerstrichmodus ist dabei als Sende-, Empfangs- oder als Sende- und Empfangsvorrichtung möglich. Für die Nutzung ausschließlich als Empfangsvorrichtung ist jedoch zu berücksichtigen, dass die LC-Oszillatoren im Betrieb immer auch ein $B_1$-Feld erzeugen (siehe oben), das gegebenenfalls manipulativ auf die Probe wirkt.

Zur Ausführung der Mittel zur Ansteuerung stehen im Dauerstrichmodus zwei Möglichkeiten zur Verfügung. In der ersten dienen als Mittel zur Ansteuerung der Anordnung von LC-Oszillatoren Mittel zur Erzeugung einer ersten Wellenform, die in die LC-Oszillatoren als Steuerspannungen eingespeist wird und gegebenenfalls einer zweiten Wellenform zur Einstellung der Hüllkurve. Diese Mittel sind zum Beispiel Digital-Analog-Wandler, gesteuert durch Personal Computer, FPGA (Field Programmable Gate Array), Mikrocontroller, "Arbitrary Waveform" Generatoren oder für einfache Rampen oder Pulse Funktionsgeneratoren. Die Wellenformen werden genutzt, um einen Frequenzsweep durch die dem bereitgestellten $B_0$-Feld entsprechende Resonanzfrequenz durchzuführen, wobei ein Signal in Sinusform im kHz-Bereich dem Sweep überlagerbar ist, um gegebenenfalls eine phasensensitive Detektion mittels eines Lock-In-Verstärkers durchzuführen. Als zweite Möglichkeit dienen die im **Aufsatz 3** von T. Yalcin und G. Boero beschriebenen Mittel zur konventionellen Feldmodulation, mit denen eine Gleichspannung an die Eingänge für die Steuerspannungen der LC-Oszillatoren gelegt wird.

Die Vorrichtung ist auch nutzbar zur Erzeugung und Detektion einer transienten Magnetisierung einer Probe. Die folgenden Ausführungen für die Erzeugung und Detektion einer transienten Magnetisierung beziehen sich auf die Nutzung der Anordnung von LC-Oszillatoren simultan sowohl als Sende- als auch als Empfangsvorrichtung. Für die anderen beiden Fälle, Nutzung jeweils nur als Sende- oder als Empfangsvorrichtung, sind nur die Teile zu berücksichtigen, die die jeweilige Funktion betreffen. Die Sende- bzw. Empfangsvorrichtungen werden dann entsprechend durch bekannte Mittel realisiert.

Ein transientes Magnetfeld $B_1(t,\omega)$ (d.h ein Magnetfeld mit zeitlich begrenzter veränderter Frequenz $\omega$) im LC-Oszillator wird durch geeignete Einspeisung von Spannungen in spannungsgesteuerte Kapazitäten (Varaktoren) erzeugt. Transiente Magnetfelder sind dabei Magnetfelder, die durch eine Änderung der Frequenz im LC-Oszillator erzeugt werden, die von beschränkter Zeitdauer ist. Die Form der Änderung ist dabei nicht beschränkt und kann z.B. stufenförmig, sägezahnförmig oder als Spitze anfallen.

Das transiente Magnetfeld $B_1(t,\omega)$ ist dabei auf eine Zeitspanne verkürzbar, die um so viel kürzer als die transiente Magnetisierung ist, dass Relaxationseffekte während des Pulses vernachlässigbar sind. Da transiente Magnetisierungen einer Probe im ESR-Fall im Sub-Nanosekundenbereich liegen können, sind auch transiente Magnetfelder mit Zeitdauern im Sub-Nanosekundenbereich (< 1 ns) für bestimmte Proben erforderlich. Die Zeitdauer der transienten Magnetisierung ist dabei über den Zusammenhang zur Spin-Gitter-Relaxationszeit ($T_1$) und Spin-Spin-Relaxationszeit ($T_2$) abhängig von der Probe.

In der erfindungsgemäßen Lösung besteht darüber hinaus vorteilhaft die Möglichkeit zur Detektion einer transienten Magnetisierung einer Probe während des Anliegens des transienten Magnetfeldes, da, anders als im Fall der aus dem Stand der Technik bekannten resonatorbasierten ESR-Detektoren, die Detektionselektronik nicht vor den starken elektromagnetischen Anregepulsen geschützt werden muss. Dies beruht auf der Tatsache, dass bei der Benutzung eines LC-Oszillators als Sende- und Empfangsvorrichtung das $B_1$-Feld zur Erregung der Magnetisierung in der Probe, im Oszillator selbst, durch den Strom in der Spule erzeugt wird. Dabei reichen aufgrund der sehr guten Umsetzung von Strom in ein $B_1$-Feld (Biot-Savart-Gesetz, Nahfeld) die im Betrieb auftretenden Ströme (je nach Größe der Spule liegen diese bei 10 mA bis 200 mA) für $B_1$-Felder, die größer als 1 mT sind aus, die wiederum die benötigten kurzen Pulse ermöglichen (10 mT entspricht etwa einer Pulslänge von 1 ns). Der Oszillator wird dabei im Betrieb zur Erzeugung üblicher Feldstärken nicht beschädigt oder irreversibel verändert. Die Zeitauflösung und die Empfindlichkeit der Messungen werden verbessert. Dies erfolgt hauptsächlich dadurch, dass die Messung eher beginnen kann (noch während der Anregung/des Pulses), und somit vor dem Einsetzen signifikanter Relaxationseffekte.

Die Dauer, Anzahl und Form der transienten Magnetfelder wird entsprechend den Anforderungen der Probe und der gewünschten Manipulation des Spinensembles in der Probe gewählt.

Im einfachsten Fall ist die Pulslänge probenabhängig so zu wählen, dass die Magnetisierung in der Probe um $\theta = 90°$ gekippt wird ($\theta = \gamma \cdot B_1 \cdot \tau_{puls}$, $\tau_{puls}$ = Zeitdauer des Anlegens des resonanten $B_1$-Feldes, $\gamma$ = gyromagnetisches Verhältnis), da so in bestimmten Fällen die transversale Magnetisierung maximiert wird, welche auch durch den erfindungsgemäßen LC-Oszillator detektiert wird. Generell lässt sich aber auch jeder andere Drehwinkel einstellen bzw. benutzen, wenn dies von Vorteil für das jeweils dezidierte Experiment ist.

Die Stärke des $B_1$-Feldes kann mit der erfindungsgemäßen Vorrichtung ausreichend groß gemacht werden, um z.B. 90°-Pulslängen ($\theta = 90°$) mit $\tau_{puls}$ im Sub-Nanosekunden Bereich zu erzeugen, so dass hierdurch in Kombination mit der Möglichkeit zur Detektion während der Anregung auch sogenannte Rabi-Oszillationen für Proben mit kurzen $T_2$-Relaxationszeiten direkt gemessen werden können. Die Stärke des $B_1$-Feldes wird dabei durch geeignete Wahl der Oszillatorversorgungsspannung bzw. des Oszillatorruhestroms sowie durch geeignete Wahl der Spuleninduktivität im Verhältnis zur frequenzbestimmenden Kapazität eingestellt.

Die an der spannungsgesteuerten Induktivität oder Kapazität der zur Anregung des Spinensembles verwendeten spannungsgesteuerten LC Oszillatoren eingespeisten Spannungen liegen in Form von zeitabhängigen Wellenformen vor. Die zeitabhängigen Wellenformen sind dadurch charakterisiert, dass sie eine Änderung in der Spannungsstärke von begrenzter Zeitdauer beinhalten. Die Änderungen in der Spannung bewirken das transiente Magnetfeld $B_1(t,\omega)$ im spannungsgesteuerten LC-Oszillator mit geänderter Frequenz. Eine Erhöhung bzw. Erniedrigung der Spannung kann dabei je nach Realisierung des Varaktors entweder zu einer Frequenzerniedrigung oder zu einer Frequenzerhöhung führen. Der Vorteil bei einem Betrieb des LC-Oszillators bei niedrigerer Oszillationsfrequenz als der Resonanzfrequenz ist, dass der LC-Oszillator insgesamt für eine niedrigere Oszillationsfrequenz entworfen werden kann. Der Vorteil bei einem Betrieb des LC-Oszillators bei höherer Oszillationsfrequenz als der Resonanzfrequenz ist, dass sich die Signaldemodulation vereinfacht. Die Form der Änderung ist dabei ebenfalls nicht beschränkt und kann z.B. stufenförmig, sägezahnförmig oder als Spitze anfallen. Die Wahl der Frequenzen richtet sich nach der erforderlichen Leistungsdichte bei den Resonanzfrequenzen der Probe. Die Dauer, Anzahl und Form der zeitabhängigen Wellenformen wird entsprechend den durch die Probe vorbestimmten Anforderungen an das transiente Magnetfeld gewählt (siehe oben).

Da durch die Spule des LC-Oszillators, sobald dieser eingeschaltet ist, ein Strom fließt, wird auch direkt ein $B_1$-Feld erzeugt. Die Amplitude des $B_1$-Feldes braucht jedoch eine gewisse Zeit, bis sie einen gewünschten Wert erreicht hat. Daher ist es vorteilhaft, den LC-Oszillator von einer ersten Frequenz, die von der Resonanzfrequenz weit genug entfernt liegt um keine Anregung in der Probe zu bewirken, nach einer zweiten Frequenz (Resonanzfrequenz) zu schalten, da so ein Einschwingvorgang auf vernachlässigbare, extrem kurze Änderungen in der Amplitude reduziert wird. Der LC-Oszillator sollte dabei generell für die Zeiten, in denen keine Anregung der Probenmagnetisierung erfolgen soll, konstant bei der ersten Frequenz betrieben werden, um Einschwingvorgänge zu vermeiden bzw. stark zu reduzieren.

Wie im Dauerstrichmodus wird eine erste, hier zeitabhängige, Wellenform als Steuerspannung den LC-Oszillatoren zugeführt.

Eine zweite, hier ebenfalls zeitabhängige, Wellenform, die zur Einstellung der Hüllkurve der transienten Magnetisierung der LC-Oszillatoren genügt, wird an den Versorgungsspannungen der LC-Oszillatoren, gegebenenfalls unter Zuhilfenahme weiterer Schaltungselemente, eingespeist. Durch eine frei wählbare Einhüllende ist vorrangig eine Vergrößerung der homogenen Bandbreite der Anregung des transienten Magnetfeldes möglich, wodurch viele spektrale Linien homogen anregbar sind.

Das transiente Magnetfeld $B_1(t,\omega)$, das so von den einzelnen LC-Oszillatoren generiert wird, genügt in Frequenz und Einhüllender (Hüllkurve) jeweils mindestens dazu, eine Magnetisierung einer Probe im $B_0$-Feld aus ihrer Gleichgewichtslage auszulenken. Dies gilt für z. B. Experimente zur Detektion von Rabi-Oszillationen, Spinechos oder bei einfachen FID (free induction decay)-Messungen, für die einzelne Pulse genügen.

Als Mittel zur Ansteuerung der Anordnung von LC-Oszillatoren dienen Mittel zur Erzeugung der ersten und zweiten zeitabhängigen Wellenform, die in die Anordnung von LC-Oszillator eingespeist werden. Diese Mittel sind zum Beispiel Digital-AnalogWandler, gesteuert durch Personal Computer, FPGA (Field Programmable Gate Array), Mikrocontroller, "Arbitrary Waveform"-Generatoren oder, für einfache Rampen, Puls-Funktionsgeneratoren.

Simultan zu dem auf die Probe einwirkenden transienten Magnetfeld $B_1(t,\omega)$ und/oder in der zeitlichen Folge auf dieses wird die zeitabhängige Änderung der Magnetisierung (Transiente) der Probe detektiert. Die Änderung der Magnetisierung der Probe bewirkt eine Änderung in den induktiven Elementen der LC-Oszillatoren, die sich als Änderung der Oszillationsfrequenz und/oder Oszillationsamplitude der LC-Oszillatoren in einer Ausgangsspannung derselben detektieren lässt. Dazu wird die Ausgangsspannung des LC-Oszillators und, gegebenenfalls, an internen Spannungsknoten direkt ein amplitudendemoduliertes Signal der Oszillatoren abgegriffen.

Die Änderungen in der Oszillationsfrequenz und/oder Oszillationsamplitude werden mit einer der Anordnung von LC-Oszillatoren nachgeschalteten Mittel zur Demodulation erfasst. Die Demodulation erfolgt dabei entweder mit einem Frequenzdemodulator oder einem Amplituden-Demodulator, wie es jeweils Ausführungsformen entspricht. Eine Kombination von einem Frequenzdemodulator mit einem Amplitudendemodulator entspricht einer weiteren Ausführungsform. Eine Umwandlung der Analogsignale in Digitalsignale erfolgt in Abhängigkeit der gewählten Wandler bzw. Demodulatoren vor oder nach der Wandlung bzw. Demodulation.

Die digitalen, gewandelten und/oder demodulierten Signale werden einem Mittel zur digitalen Datenverarbeitung zugeführt. Sie werden dort in ein Modell transienter Induktivität und transienten Widerstands einer Spule zur Ermittlung der ursprünglichen Spektrallinien einer Probe eingegeben, zur Ermittlung von Resonanzenergien, z.B. ausgedrückt über den Landé-Faktor ($g$-Faktor / $g$-Tensor) oder das Verhältnis von Resonanzfrequenzen einer Probe und $B_0$.

Das Modell transienter Induktivität und transienten Widerstands einer Spule ist in der Deutschen Patentanmeldung mit dem Aktenzeichen DE 10 2015 120 644.7 im Detail hergeleitet. Diesem Modell nach ist die Frequenz eines LC-Oszillators, der eine Probe mit einer zeitlich veränderlichen Magnetisierung in der erregbaren Region seiner Spule aufweist, aufgestellt gemäß dem Term

$$\omega_{osc,\chi} = \frac{1}{\sqrt{L_0 \cdot C}} - \frac{1}{2} \cdot \frac{1}{(L_0 \cdot C)^{\frac{3}{2}}} \cdot C \cdot \Delta L_{sample} \qquad (1.1)$$

$$= \frac{1}{\sqrt{L_0 \cdot C}} - \frac{1}{2} \cdot \frac{1}{(L_0 \cdot C)^{\frac{1}{2}}} \cdot \frac{\Delta L_{sample}}{L_0}$$

$$= \omega_{osc0} - \frac{1}{2} \cdot \omega_{osc0} \cdot \frac{\Delta L_{sample}}{L_0}$$

mit $C$ = Kapazität der Spule, $L_0$ = probenunabhängige Induktivität der Spule, $\Delta L_{sample}$ = probenabhängigen Änderung der Induktivität der Spule.

Gemäß dem Modell transienter Induktivität und transienten Widerstands einer Spule, in dem eine Induktivität $L(t)$ der Spule ersetzt ist durch eine Kombination eines von der Probe unabhängigen Ausdrucks $L_0$ der Induktivität der Spule und eines von der Probe abhängigen Ausdrucks $\Delta L_{sample}$ für die detektierbare Induktivität der Probe im transienten Magnetfeld gemäß

$L(t) = L_0(t) + \Delta L_{sample}(t)$, sind die folgenden Ausdrücke für $L_0$, $\Delta L_{sample}$ und $R_{sample}$ (zeitlich veränderlicher Verlust in der Spule, welcher durch die Magnetisierung der Probe verursacht wird) aufgestellt:

$$L_0 \equiv 2 \cdot \int_V \left[ \frac{1}{\mu_0} \cdot \vec{B}_u^2(\vec{r}) \right] dV \qquad (1.2)$$

$$\Delta L_{sample}(t) \equiv \int_{V_s} \left[ -\vec{B}_u(\vec{r}) \cdot \frac{\vec{M}(t,\vec{r})}{i(t)} \right] dV \qquad (1.3)$$

$$\frac{d}{dt}\Delta L_{\text{sample}}(t) + R_{\text{sample}}(t) = \int_{V_s}\left[-\vec{B}_u(\vec{r}) \cdot \frac{\frac{d}{dt}[\vec{M}(t,\vec{r})]}{i(t)}\right]dV \qquad (1.4)$$

$$\leftrightarrow R_{\text{sample}}(t) \equiv \int_{V_s}\left[-\vec{B}_u(\vec{r}) \cdot \frac{\frac{d}{dt}[\vec{M}(t,\vec{r})]}{i(t)}\right]dV - \frac{d}{dt}\Delta L_{\text{sample}}(t), \qquad (1.5)$$

mit $V$ = Volumen, $V_s$, = Probenvolumen, $\vec{B}_u$ = unitäres Magnetfeld, $i(t)$ = der zum Spannungabfall $v(t)$ der Spule zugehörige Stromfluss und $\vec{M}$ = makroskopische Magnetisierung, Magnetisierung der Probe. Die Größe $L_0$ kann direkt über die Geometrie der Spule ermittelt werden.

Aus der Gleichung (1.5) folgt, dass die Gegenwart einer zeitlich veränderlichen Magnetisierung zu einer Änderung der Induktivität in der Probe führt, welche proportional ist zum Integral besagter Magnetisierung über die gesamte Probe, welches normiert ist auf den Stromfluss in der Induktionsspule gemäß

$$\Delta L_{\text{sample}}(t) \equiv \int_{V_s}\left[-\vec{B}_u(\vec{r}) \cdot \frac{\vec{M}(t,\vec{r})}{i(t)}\right]dV = \int_{V_s}[-\vec{B}_1(\vec{r}) \cdot \frac{\vec{M}(t,\vec{r})}{i^2(t)}]dV \qquad (1.6)$$

Da die auf die Probe bezogene Induktivität $\Delta L_{\text{sample}}$ proportional ist zum Integral der Magnetisierung der Probe (normiert auf den Stromfluss in der Spule) ist eine zeitlich veränderliche Magnetisierung einer Probe ermittelbar durch Erfassen des instantanen Wertes der Oszillationsfrequenz des LC-Oszillators ($\omega_{osc,\chi}$). Zusätzlich bewirken die zur Probe gehörigen spektralen Komponenten der Induktivität bei $\omega_{osc0} \pm \omega_i$, die durch die Änderung der Induktivität des probenbezogenen Anteils $\Delta L_{sample}$ hervorgerufen werden, eine Modulation der Frequenz des Oszillators mit der Modulationsfrequenz $\omega_{osc0} \pm \omega_i$ und erzeugen somit spektrale Komponenten in der Spannung des Oszillators bei $\omega_{osc0} \pm (\omega_{osc0} \pm \omega_i)$. Diese spektralen Komponenten sind durch gängige Demodulation der Frequenzen (FM, Frequenzmodulation) ermittelbar, woraus auch die Induktivität der Probe $\Delta L_{\text{sample}}$ bestimmbar ist und folglich auch deren Magnetisierung bzw. die zugehörigen spektralen Komponenten und resonantes Verhalten. Mithin sind die Intensität und die Dynamik der Magnetisierung einer Probe mit hoher Zeitauflösung erfassbar.

Die Oszillationsamplitude eines Oszillators hängt stark vom Widerstand der Spule ab. Verallgemeinert kann von folgendem Term für die Oszillationsamplitude $A_{osc}$ eines LC-Oszillators, vorgespannt durch eine Stromquelle, ausgegangen werden:

$$A_{osc} = A_{osc}\Big|_{R_{eff}=R_0} + \frac{\partial A_{osc}}{\partial R_{eff}}\Big|_{R_{eff}=R_0} \cdot R_{sample,tot} \qquad (1.8)$$

mit $R_{eff}$ = effektiver Widerstand der Spule, $R_0$ = ohmscher Spulenwiderstand und
$R_{sample,tot}$ = durch die Probe induzierter Widerstand der Spule.

Im Falle eines LC-Tank-VCO mit Stromquelle zur Speisung des kreuzgekoppelten Transistorpaars konkretisiert sich die Gleichung (1.8) zu

$$A_{osc} = 8 \cdot \sqrt{\frac{2}{3}} \cdot \frac{n \cdot I_{\text{BIAS}}}{G_m} \cdot \sqrt{1 - \frac{2 \cdot R_0}{\omega_{LC}^2 \cdot L_0^2}} + \frac{\partial A_{osc}}{\partial R_{\text{eff}}}\Big|_{R_{\text{eff}}=R_0} \cdot R_{\text{sample,tot}} \qquad (1.9)$$

mit $n$ = Emissionsfaktor im Unterschwellenbereich und $I_{BIAS}$ = DC-Ruhestrom des Oszillators (Biasstrom).

Die Aufstellung der Funktionen (1.8) und (1.9) erfolgt auf der Grundlage, dass unter den meisten experimentellen Bedingungen der Spulenwiderstand $R_0$ signifikant größer ist als die durch die Probe induzierte Änderung im Spulenwiderstand $R_{\text{sample,tot}}$. Im Gegensatz zur durch die Probe induzierten Änderung der Induktivität $\Delta L_{\text{sample}}$, führt die durch die Probe induzierte Änderung im Widerstand $R_{\text{sample,tot}}$ zu Modulationen der Amplitude der Oszillationsfrequenz der Spule, welche spektrale Anteile in der Oszillatorausgangsspannung bei $\omega_{osc0} \pm (\omega_{osc0} \pm \omega_i)$ bewirken, die wiederum mit gängiger Demodulation der Amplitude (AM, Amplitudendemodulation) ermittelt werden können und somit auch die Magnetisierung bzw. die zugehörigen spektralen Komponenten und resonantes Verhalten.

Die im dem Modell transienter Induktivität und transienten Widerstands einer Spule aufgestellten Funktionen und Beziehungen sind durch eine entsprechende Wahl der Parametern auch für den Dauerstrichmodus gültig.

Dementsprechend können nach konventioneller FM- bzw. AM-Demodulation die spektralen Komponenten der Magnetisierung bei Frequenzen von $\omega_{osc0} \pm \omega_i$ detektiert werden und, da die Oszillationsfrequenz $\omega_{osc0}$ bekannt ist, somit eindeutig und quantitativ spektralen Komponenten bei den Frequenzen $\omega_i$ zugeordnet werden.

FM- und AM-Demodulation können unterschiedlich komplex in der Durchführung sein, so dass sich hier Unterschiede in der Detektorhardware ergeben. Zum Beispiel gibt es beim LC-Tank-Oszillator einen Knoten mit der intrinsischen AM-Demodulation, an der diese abgegriffen werden kann. Grundlagen zur Amplitudendetektion in einem CMOS-LC-Oszillator sind in dem **Aufsatz 6** von P. Kinget (Amplitude detection inside CMOS LC oscillators, 2006 IEEE International Symposium on Circuits and Systems, Vol. 1-11, Proceedings 2006, S. 5147-5150) gegeben. Für die FM-Demodulation kommen z.B. Phasenregelschleifen (analog oder digital) oder sogenannte Teager-Energie-Operatoren zum Einsatz.

Eine Erfassung beider Spektren (Frequenz und Amplitude der Ausgangsspannung) birgt den Vorteil, dass eine intrinsische "Baseline Calibration" vorgenommen werden kann, d.h. spektrale Komponenten, die in beiden Spektren auftauchen, sind als echt aufzufassen, bei allen anderen handelt es sich hingegen um sogenannte Messartefakte.

Das Mittel zur Bestimmung spektraler Komponenten der Probe, das auf dem Mittel zur digitalen Datenverarbeitung bereitgestellt ist, z.B. in Form eines Computerprogramms, umfasst im Fall der transienten Magnetisierungen der Probe Terme, die den Termen (1.1) oder/und (1.8) entsprechen, wobei die Terme (1.2) bis (1.6) des Modells transienter Induktivität und transienten Widerstands einer Spule berücksichtigt sind, wie es auch Ausführungsformen entspricht. Im Fall eines Experiments im Dauerstrichmodus umfasst das Mittel zur Bestimmung spektraler Komponenten der Probe einen Term, der dem Term (0.3) entspricht.

Die ermittelten spektralen Komponenten, im Dauerstichmodus und im Fall transienter Magnetisierung der Probe, dienen zur Bestimmung von Spinkonzentrationen (auch zeitlich vibrierend) von Spektralkomponenten bestimmter Spin-Ensembles sowie deren Resonanzenergien, z.B. ausgedrückt über den Landé-Faktor (g-Faktor / g-Tensor) oder dem Verhältnis von Resonanzfrequenzen einer Probe und $B_0$, und werden mit dazu geeigneten Mitteln ausgegeben, die ebenfalls auf dem Mittel zur digitalen Datenverarbeitung bereitgestellt sind. Die ausgegebenen Informationen sind dann z.B. für einen Einsatz in einer Prozessführung oder einer Qualitätskontrolle sowie zur bildgebenden Magnetresonanztomographie nutzbar.

Für einige Anwendungen, z.B. bei transienten Experimenten und um Artefakte zu unterdrücken, ist es in ESR- und NMR-Experimenten notwendig die Phase des anregenden $B_1$-Feldes gezielt einzustellen, um so gezielt den Kohärenztransferpfad (engl. coherence transfer pathway) einzustellen. Dies kann bei Verwendung der erfindungsgemäßen Anordnung von LC-Oszillatoren in der Funktion als Empfangsvorrichtung dadurch realisiert werden, dass zumindest einer der LC-Oszillatoren als spannungsgesteuerter Oszillator realisiert wird, um so eine Synchronisation mit einer externen Referenzfrequenz, z.B. mittels einer Phasenregelschleife zu realisieren, so dass alle LC-Oszillatoren in der Anordnung der Referenzfrequenz folgen, wie es einer Ausführungsform entspricht. Gepulste Experimente können dann durch Umschalten, z.B. mittels eines analogen Multiplexers, zwischen zwei verschiedenen Referenzfrequenzen, die einer Oszillationsfrequenz der Anordnung in Resonanz bzw. außerhalb der Resonanz entsprechen, realisiert werden. Ein sogenanntes Phase-Cycling kann zusätzlich durch Umschalten zwischen verschiedenen Referenzsignalen mit gleicher Frequenz (in Resonanz) und unterschiedlichen Phasen implementiert werden. Die verschiedenen Phasen können vorteilhaft z.B. durch Frequenzteiler von einer höheren Referenzfrequenz erzeugt werden. Durch das Phase-Cycling, d.h. die sukzessive Anregung mit Pulsen unterschiedlicher Phase, können gezielt Signale, die bestimmten Übergängen entsprechen, unterdrückt bzw. ausgelesen werden.

Die erfindungsgemäße Anordnung von LC-Oszillatoren ist in integrierter Schaltungstechnik ausführbar, d.h. vollständig mit aktiven Elementen. Die Anzahl diskreter Komponenten wird reduziert und gegebenenfalls sind keine weiteren externen Komponenten nötig. Dies ermöglicht die Realisierung kostengünstiger, leistungsarmer und unter Umständen transportabler Geräte. Vorteilhaft für die erfindungsgemäße Vorrichtung ist die symmetrische Ausführbarkeit und hohe Reproduzierbarkeit der einzelnen Schaltungselemente, wie sie z.B. in MEMS-Technologie möglich ist. Dadurch können Störsignale reduziert werden (besonders bei Amplitudendetektion).

Durch die erfindungsgemäße Anordnung von frequenzsynchronisierten LC-Oszillatoren ist zudem das Rauschen verbessert. Die in der Frequenz synchronisierte Anordnung von LC-Oszillatoren zeigt die Charakteristik eines einzelnen Oszillators, dessen Rauschen durch einen injizierenden Oszillator (Master) bestimmt ist.

Die erfindungsgemäße Vorrichtung ermöglicht erstmals mit verbesserter Spinsensitivität und auch verbesserter Konzentrationssensitivität eine Erzeugung und Detektion von Magnetisierungen einer Probe sowohl im Dauerstrichmodus als auch im Fall transienter Magnetisierung einer Probe. Mittels Abgreifen der amplitudenmodulierten Signale an den einzelnen LC-Oszillatoren in der Anordnung ist auch bei Bedarf zusätzlich ein ortsaufgelöstes Signal verfügbar. Die Vorrichtung ist zudem vereinfacht gegenüber dem Stand der Technik ausführbar und ohne großen Aufwand an verschiedene Probenumgebungen anpassbar. Die vereinfachte Ausführung resultiert aus der Verringerung von Komponenten, da nicht pro LC-Oszillator in der Anordnung Mittel zur Signalverarbeitung für die Frequenzmodulation erforderlich sind und zudem die Sendevorrichtung und die Empfangsvorrichtung in einer Anordnung (d.h. als eine Vorrichtung mit beiden Funktionen) ausführbar sind. Die Reduktion der erforderlichen Mittel zur Signalverarbeitung ergibt sich aus der Tatsache, dass die LC-Oszillatoren in der Anordnung synchronisiert sind und somit nur die Frequenz der Ausgangsspannung der Anordnung bestimmt werden muss. Darüber hinaus erfolgt die Anregung der Spins in integrierter Form, d.h. jeder LC-Oszillator in der Anordnung fungiert als Sendevorrichtung.

Die erfindungsgemäße Vorrichtung ist in allen Bereichen, in denen standardmäßig ESR- und NMR-Experimente durchgeführt werden, insbesondere auch in bildgebenden Verfahren der Medizintechnik (Magnetresonanztomographie, MRT) einsetzbar.

Ausführungsbeispiel

Die Erfindung soll in Ausführungsbeispielen und anhand von Figuren näher erläutert werden.

Die Figuren zeigen:

Fig. 1:    Schematische Darstellung einer Vorrichtung zur Erzeugung und Detektion magnetischer Resonanz.

Fig. 2:    Schematische Darstellung einer Anordnung von LC-Oszillatoren als flächenhaftes Verbundsystem.

Fig. 3:    Schematische Darstellung einer Anordnung von LC-Oszillatoren, die als Koppelnetzwerk verschaltet sind.

Fig. 4:    Aufbau eines LC-VCO zur Erzeugung und Detektion einer transienten Magnetisierung.

Fig. 5:    Schematische Darstellung einer Anordnung von LC-Oszillatoren, die als Netzwerk verschaltet sind.

Fig. 6:    Aufbau eines LC-VCO zur Erzeugung und Detektion einer transienten Magnetisierung in einer Anordnung gemäß Figur 5.

Fig. 7:    Schematische Darstellung einer Vorrichtung zur Erzeugung und Detektion magnetischer Resonanz, in der die Anordnung sowohl als Sendevorrichtung als auch als Empfangsvorrichtung dient und das Magnetfeld $B_0$ durchstimmbar ist.

Fig. 8:    Schematische Darstellung einer Vorrichtung zur Erzeugung und Detektion magnetischer Resonanz, in der die Anordnung sowohl als Sendevorrichtung als auch als Empfangsvorrichtung dient und das Magnetfeld $B_0$ durchstimmbar ist.

Fig. 9:    Simulation der gemeinsamen Oszillationsfrequenzen einer Anordnung von LC-Oszillatoren als Funktion der Steuerspannung.

Fig. 10:   Simulation des Verhaltens der gemeinsamen Oszillationsfrequenz einer Anordnung von vier LC- Oszillatoren in einem Dauerstrichexperiment wie in Fig. 7 gezeigt, mit jeweils einer Probe mit jeweils verschiedenem $g$-Faktor und verschiedener Probenkonzentration pro LC-Oszillator, bei einem Durchstimmen der Feldstärke.

Fig. 11:   Simulation des Verhaltens der gemeinsamen Oszillationsfrequenz einer Anordnung von vier LC- Oszillatoren in einem Dauerstrichexperiment wie in Fig. 8 gezeigt, mit jeweils einer Probe mit jeweils verschiedenem I-Faktor und verschiedener Probenkonzentration pro LC-Oszillator, bei einem Durchstimmen der freien Oszillationsfrequenz der LC-Oszillatoren.

Fig.12:    Schematische Darstellung einer flächenhaften Anordnung von LC-Oszillatoren in Spalten und Reihen, die als Koppelnetzwerk verschaltet sind.

Fig. 13:   Schematische Darstellung einer flächenhaften Anordnung von LC-Oszillatoren mit Hilfseingängen in Spalten und Reihen, die als Netzwerk verschaltet sind.

Fig. 14:   Schematische Darstellung einer Anordnung von LC-Oszillatoren, eingebunden in einen Phasenregelschleife mit zwei Referenzoszillatoren.

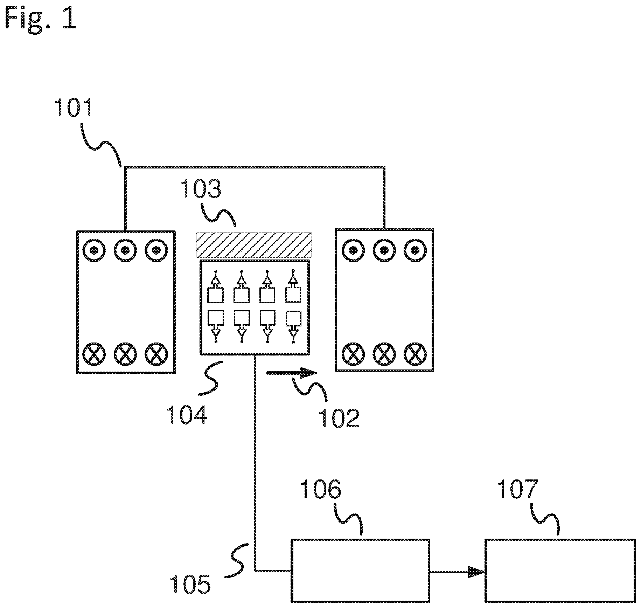

In der Fig. 1 ist eine schematische Darstellung einer erfindungsgemäßen Vorrichtung zur Erzeugung und Detektion einer Magnetisierung einer Probe gezeigt. Ein Magnet **101,** der zum Beispiel ein supraleitender Magnet, ein Elektromagnet beliebiger Ausführung, ein Permanentmagnet oder ein interner probenintrinsischer Magnet (z.B. Dipolfelder) sein kann, stellt das statische Magnetfeld $B_0$ **102** an einem Probenort, an dem eine Probe **103** angeordnet ist, zur Verfügung. Das Magnetfeld $B_0$ **102** induziert in der Probe **103** eine Magnetisierung entsprechend der Suszeptibilität der Probe **103**. Eine Anordnung von LC-Oszillatoren **104** erzeugt ein zusätzliches Magnetfeld $B_1$. Die Anordnung von LC-Oszillatoren **104** wird angesteuert durch eine zeitabhängige Wellenform, die als Steuerspannung $V_{(tun, \omega osc)}$ dient, durch welche die Frequenz der Oszillatoren in der Anordnung **104** bestimmt ist, und eine zweite zeitabhängige Wellenform, die zur Manipulation der Amplitude der Oszillation der LC-Oszillatoren in der Anordnung **104** $V_{(tun,Aosc)}$ dient (nicht gezeigt). Die zeitabhängigen Wellenformen können durch einen Personal Computer/digitale Datenverarbeitungsvorrichtung (nicht gezeigt) bereitgestellt und durch Digital-Analog-Umsetzer (nicht gezeigt) konvertiert werden. Die Ausgangsspannung $V_{(osc, out)}$ **105** der Anordnung von LC-Oszillatoren **104** wird einem FM -Demodulator **106** zugeführt, durch Analog-Digital-Umsetzer (nicht gezeigt) konvertiert und dann einer Datenverarbeitung **107** übergeben, von der aus ermittelte Werte ausgegeben werden. Informationen über die Probe **103**, die in der Frequenz der Ausgangsspannung **105** der Anordnung von LC-Oszillatoren enthalten ist (beispielsweise Resonanzenergien), werden für eine Weiterverarbeitung, z.B. in der Bildgebung oder Prozessführung, ausgegeben.

Das magnetische Feld, das erzeugt wird durch die stromdurchflossenen Spulen im Inneren der LC-Oszillatoren der Anordnung **104,** wird zur Manipulation einer Magnetisierung einer Probe **103** genutzt. Die resultierende Änderung der Probenmagnetisierung verursacht wiederum eine Änderung in der Induktivität der Spulen. Diese Änderung in den einzelnen Spulen verursacht dann eine Änderung in der Frequenz der Anordnung von frequenzsynchronisierten LC-Oszillatoren **104.** Die Anordnung von frequenzsynchronisierten LC-Oszillatoren **104** stellt somit eine Sendevorrichtung mit ausgedehnter aktiver Fläche dar. Darüber hinaus stellt sie simultan auch eine Empfangsvorrichtung für die in einer Probe bewirkten Änderungen der Magnetisierung dar, die über die Oszillationsfrequenz der Anordnung **104,** die eine gemeinsame Oszillationsfrequenz der gekoppelten, frequenzsynchronisierten LC-Oszillatoren ist, bestimmbar ist.

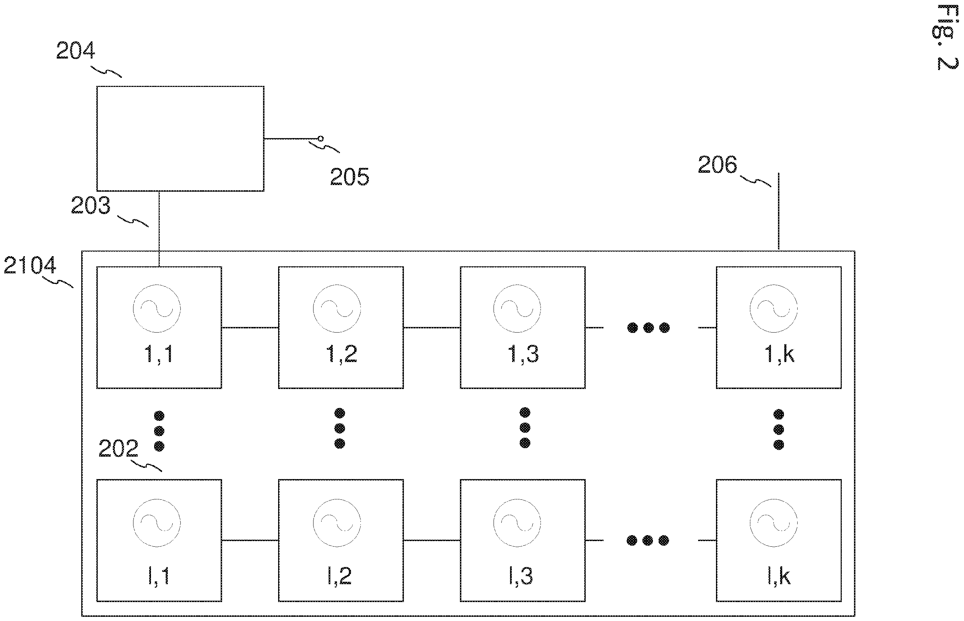

Eine verallgemeinerte Darstellung einer Anordnung **2104** von frequenzsynchronisierten LC-Oszillatoren **202** für einen Einsatz als Sende- oder Empfangsvorrichtung sowie einer Kombination aus beiden ist in Fig. 2 gezeigt. Die geometrische Anordnung der LC-Oszillatoren erfolgt als flächenhaftes Verbundsystem von einzelnen LC-Oszillatoren **202** in Reihen ($l$) und Spalten ($k$) (l, k), was aus dem Englischen entlehnt auch als "Array" bezeichnet wird. Die gemeinsame Oszillationsfrequenz $\omega_{osc,Array}$ der einzelnen ($l \times k$) gekoppelten, frequenzsynchronisierten LC-Oszillatoren **202** wird in der Ausgangsspannung **203** der Anordnung **2104** bestimmt. Diese wird demoduliert und prozessiert in der Ausleseelektronik **204,** die z.B. FM- und AM-Demodulatoren, Analog-Digital-Umsetzer und Datenverarbeitungsanlagen umfassen kann. Die gemeinsame Oszillationsfrequenz der Anordnung **2104** von LC-Oszillatoren kann von außerhalb durch eine einzelne oder ein Set von Steuerspannungen $V_{tune}$ **206** kontrolliert werden.

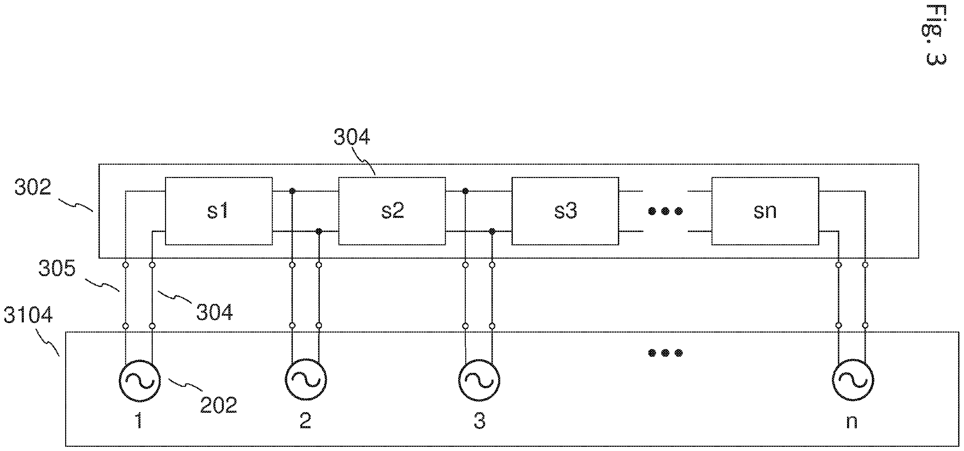

Ein Ausführungsbeispiel einer möglichen Verschaltung zur Frequenzsynchronisation der einzelnen LC-Oszillatoren **202** in einer Anordnung **3104** ist in Fig. 3 gezeigt. Hier wird der Ausgang **305** jedes einzelnen Oszillators (1, 2,..., n) **202** in den Ausgang **304** eines anderen Oszillators **202** gespeist. Dies erfolgt durch ein Koppelnetzwerk **302,** das gewährleistet, dass der Ausgang der einzelnen Oszillatoren **202** durch Netzwerkbereiche (s1, s2,..., sn) **304** in einzelne oder mehrere andere Oszillatoren **202** gespeist wird. In der Fig. 3 ist der Einfachheit halber lediglich der Fall gezeigt, in dem der Ausgang einzelner Oszillatoren **202** in einzelne andere Oszillatoren **202** gespeist wird. Das Koppelnetzwerk **302** gewährleistet die Frequenzsynchronisation durch sogenanntes "Injection locking" (Verriegelung/Synchronisation durch Zufuhr/Injektion einer Frequenz), welches bewirkt, dass alle Oszillatoren **202** im Netzwerk **302** bei einer Frequenz $\omega_{(osc,array)}$ oszillieren.

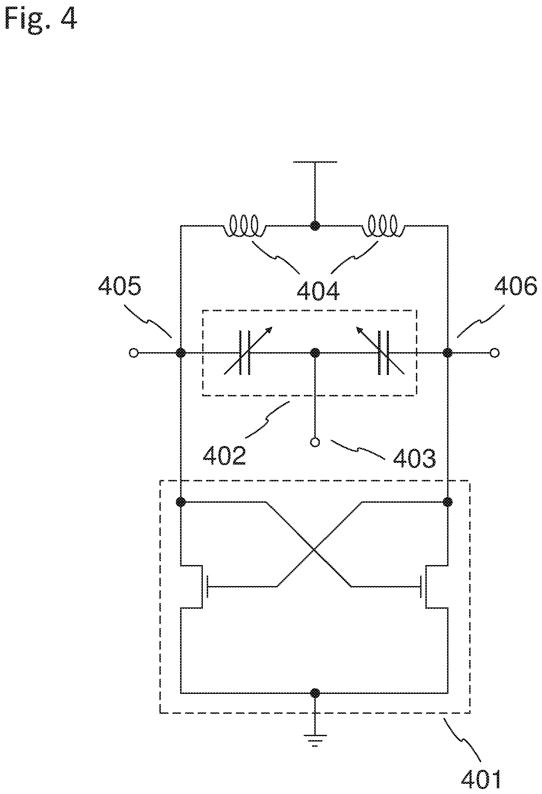

In der Fig. 4 ist der Aufbau eines LC-VCO zur Verwendung als LC-Oszillator in einer erfindungsgemäßen Vorrichtung zur Erzeugung und Detektion einer Magnetisierung gezeigt, wie er auch einer Ausführungsform entspricht. Eine differentielle Kapazitätsdiode (Varaktor) **402** und eine differentielle Induktivität **404** dienen zur Bildung des LC-Schwingkreises. Zwei kreuzgekoppelte Transistoren **401** gewährleisten eine stabile Oszillation im differentiellen Output (d.h. der Ausgangsspannung) durch negativen Widerstand und Nichtlinearität zwischen zwei Knotenpunkten **405** / **406.** Die Abstimmungseigenschaften werden durch die differentielle Kapazitätsdiode **402** mit der Steuerspannung **403** gewährleistet. Die zeitabhängige Variation der Oszillationsamplitude wird z.B. umgesetzt durch eine Manipulation der Spannungsversorgung des LC-VCO. Die Oszillationsamplitude wird durch die Modulation der Versorgungsspannung realisiert. Diese einfache Ausführung eines LC-VCO gewährleistet eine geringe Leistungsaufnahme, geringen Platzbedarf und arbeitet zudem auch bei niedrigen (bis zu kryogenen) Temperaturen.

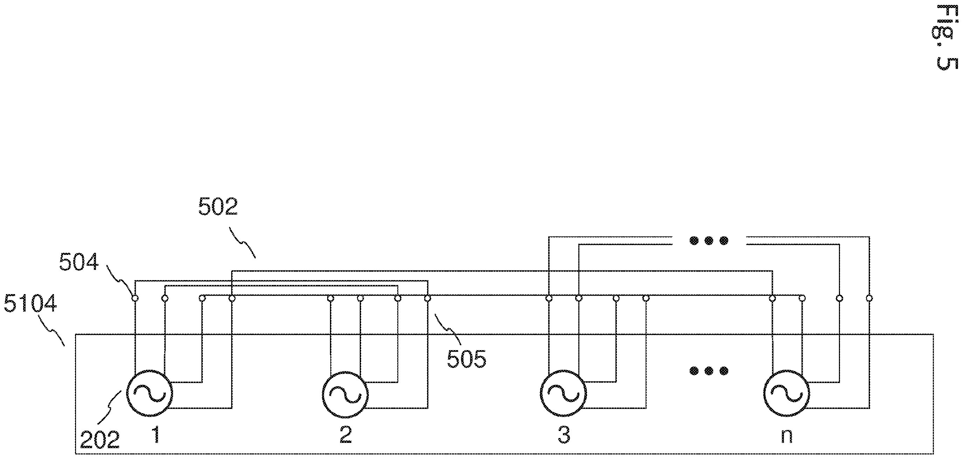

Ein weiteres Ausführungsbeispiel einer möglichen Verschaltung zur Frequenzsynchronisation der einzelnen LC-Oszillatoren (1, 2,..., n) **202** einer Anordnung **5104** ist in Fig. 5 gezeigt. Hier weist jeder Oszillator **202** der Anordnung **5104** einen zusätzlichen Eingang **505** auf, in den das Ausgangssignal **504** eines oder mehrerer anderer Oszillatoren eingespeist wird. Die Verbindung **502** zur Einspeisung erfolgt wechselseitig zwischen den einzelnen Oszillatoren und bewirkt eine gemeinsame Oszillationsfrequenz $\omega_{(osc,array)}$ der Anordnung **5104.**

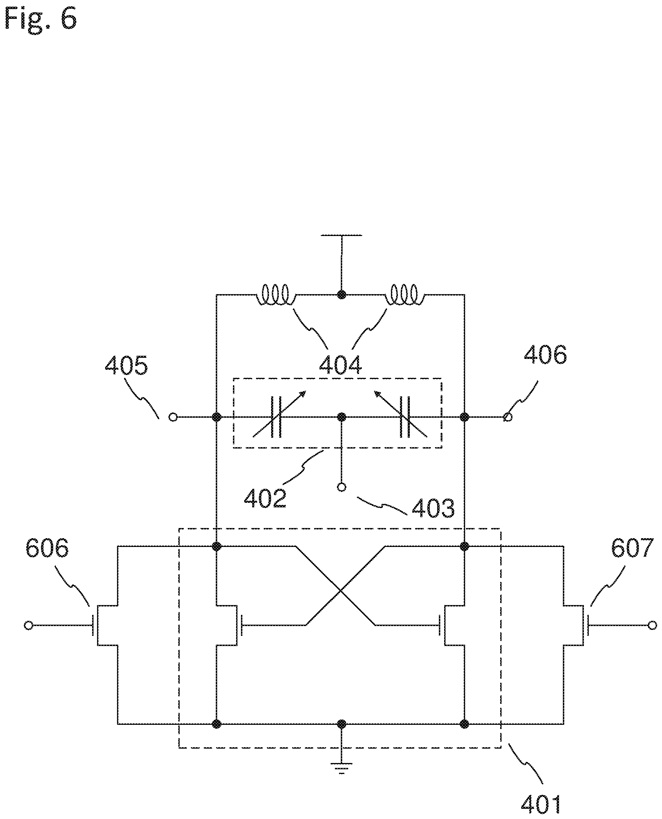

Ein LC-Oszillator, wie er in einer Anordnung gemäß der Figur 5 verwendet werden kann, ist in Fig. 6 gezeigt. Der Oszillator entspricht einem LC-Tank-Oszillator mit einem negativen Widerstand, welcher durch das kreuzgekoppelte Transistorenpaar **401** gegeben ist. Der LC-Tank ist dabei gebildet durch das induktive Element **404** und das kapazitive Element **402,** welches durch die Steuerspannung $V_{tune}$, die an Eingängen **403** eingespeist wird, spannungsgesteuert ist. Zusätzliche Eingänge **606/607,** welche zur Frequenzsynchronisation nutzbar sind, sind an den Transistor-Gates bereitgestellt. Die Ausgangsspannung des Oszillators, die zur Speisung der genannten Eingänge an anderen Oszillatoren der Anordnung genutzt wird, wird an den Knoten **405/406** abgegriffen.

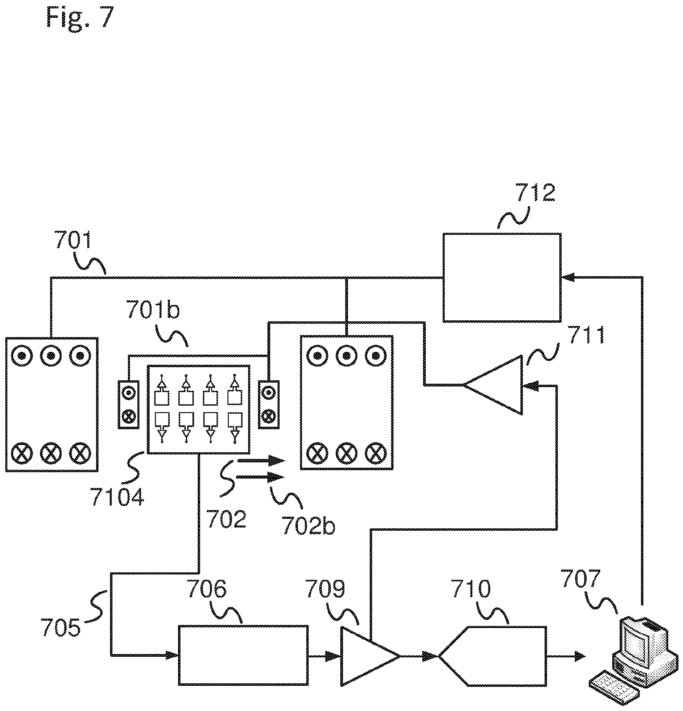

Ein Ausführungsbeispiel zur Nutzung einer erfindungsgemäßen Vorrichtung für Experimente mit Feld-Modulation ist in Fig. 7 gezeigt. Die Anordnung von LC-Oszillatoren **7104** ist hier simultan sowohl als Sendevorrichtung, zur Manipulation der Magnetisierung einer Probe (nicht gezeigt), als auch als Empfangsvorrichtung, zur Detektion der Änderung der Magnetisierung der Probe, genutzt. Die Detektion der Änderung der Magnetisierung einer Probe erfolgt dabei durch die Änderung der Frequenz der Ausgansspannung $\omega_{(osc,array)}$ **705.** Das Experiment wird durchgeführt während das statische $B_0$-Feld **702** durchgestimmt wird. Die Durchstimmung erfolgt durch die Nutzung eines variablen Feldmagneten **701,** dessen Feld durch ein zusätzliches Modulationsfeld $B_m$ **702b,** das durch Modulationsspulen **701b** erzeugt wird, moduliert wird. Dies erlaubt eine phasensensitive Detektion des mit einem FM-Demodulator **706** demodulierten Ausgangssignals mit Hilfe eines Lock-in-Verstärkers **709.** Das Ausgangssignal des Lock-in-Verstärkers wird mit einem gebräuchlichen Analog-Digital-Umsetzer **710** digitalisiert für die weitere Prozessierung. Diese findet in einer Datenverarbeitungsanlage **707** statt, auf der Mittel zur Bestimmung der spektralen Komponenten der Probe auf Grundlage des Modells transienter Induktivität und transienten Widerstands einer Spule in Form eines Computerprogramms (nicht gezeigt) und Mittel zur Ausgabe der ermittelten Werte (ebenfalls nicht gezeigt) bereitgestellt sind. Ein Leistungsverstärker **711** stellt den Strom (meist zwischen einigen 10 mA und einigen 100 mA) bereit, der benötigt wird, um ein ausreichend großes (probenabhängig, meist zwischen einigen 1 $\mu$T und einigen 100 $\mu$T) Modulationsmagentfeld $B_m$ zu erzeugen. Eine Steuereinheit **712** wird von der Datenverarbeitungsanlage **707** durch Steuersignale gesteuert um einen Frequenzsweep des $B_0$-Feldes durchzuführen.

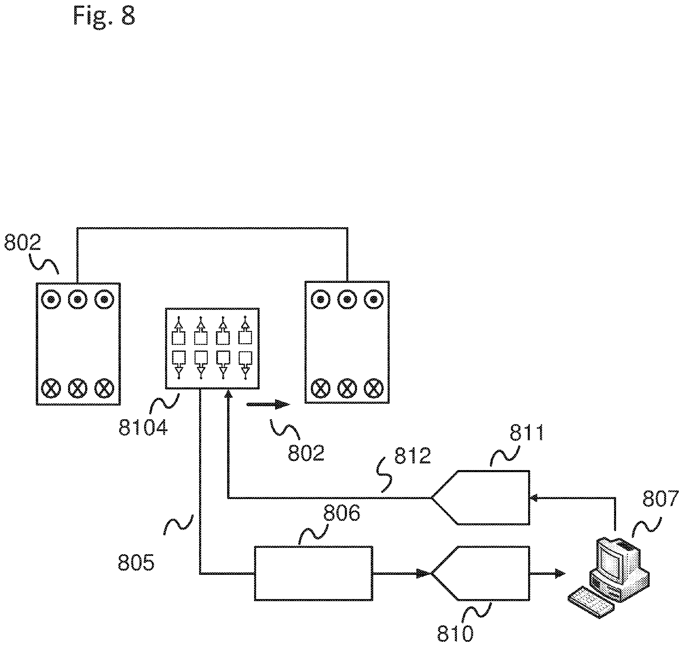

Ein weiteres Ausführungsbeispiel zur Nutzung einer erfindungsgemäßen Vorrichtung für Experimente mit transienten Magnetfeldern ist in Fig. 8 gezeigt. Die Anordnung von frequenzsynchronisierten LC-Oszillatoren **801** wird hier genutzt zur Erzeugung eines transienten Magnetfeldes. Dieses wird unter Nutzung einer oder mehrerer zeitabhängiger Wellenformen, welche als Steuerspannungen **812** für die LC-Oszillatoren in der Anordnung **801** dienen und von einer digitalen Datenverarbeitungsanlage **807** bereitgestellt werden sowie mit Digital-Analog-Umsetzern **811** konvertiert werden, erzeugt. Die eine oder mehreren Steuerspannungen **812** werden in einen, mehrere oder alle Eingänge der Steuerspannung der LC-Oszillatoren eingespeist. Das dadurch in den LC-Oszillatoren der Anordnung **801** erzeugte transiente Magnetfeld wird zur Manipulation der Magnetisierung einer Probe (nicht gezeigt) genutzt. Die Änderung der Magnetisierung einer Probe wird über die Änderung in der Oszillationsfrequenz $\omega_{(osc,array)}$ der Ausgangsspannung **805** der Anordnung **804** detektiert. Hierzu wird die Ausgangsspannung **805** der Anordnung in einem FM-Demodulator **806** demoduliert, anschließend in einem Analog-Digital-Umsetzer **810** digitalisiert und dann der Datenverarbeitungsanlage **807** zugeführt. In der Datenverarbeitungsanlage **807** sind Mittel zur Bestimmung der spektralen Komponenten der Probe auf Grundlage des Modells transienter Induktivität und transienten Widerstands einer Spule in Form eines Computerprogramms (nicht gezeigt) und Mittel zur Ausgabe der ermittelten Werte (ebenfalls nicht gezeigt) bereitgestellt.

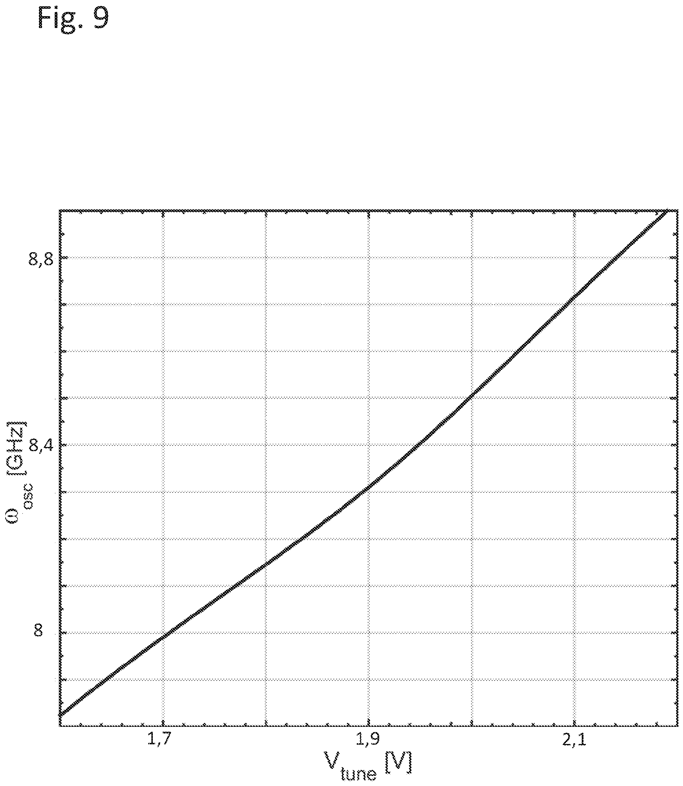

In Fig. 9 ist eine Simulation der Abhängigkeit der Oszillationsfrequenz der Ausgangsspannung $\omega_{(osc,array)}$ einer Anordnung von frequenzsynchronisierten LC-Oszillationen gemäß der Fig. 5 und Fig. 6 von der Steuerspannung gezeigt. Wie deutlich erkennbar, folgt die Oszillationsfrequenz der Ausgangsspannung der Anordnung der Änderung der Steuerspannung der einzelnen LC-Oszillatoren in der Anordnung.

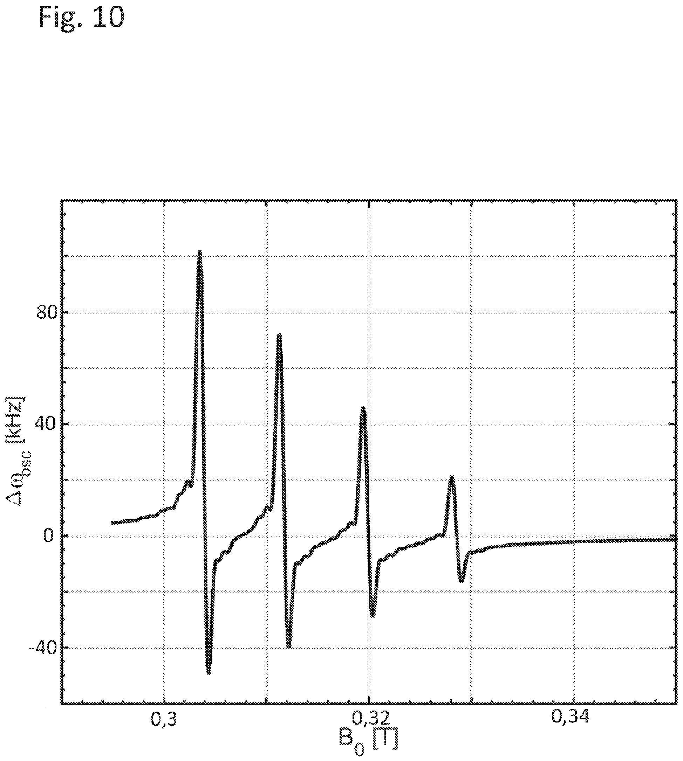

Eine Simulation der Änderung in der Oszillationsfrequenz einer Ausgangsspannung $\Delta\omega_{(osc,array)}$ einer Anordnung von vier frequenzsynchronisierten LC-Oszillatoren, gemäß der Fig. 5 und Fig. 6, ist in Fig. 10 gezeigt. Die Änderung wird von vier Proben mit jeweils unterschiedlichen $g$-Faktoren, die im Bereich der aktiven Fläche der Anordnung von LC-Oszillatoren angeordnet sind, während eines ESR-Experiments im Dauerstrichmodus hervorgerufen. Der experimentelle Aufbau entspricht dabei dem in Fig. 7. Wie aus der Figur ersichtlich, ist die jeweilige Änderung in der Magnetisierung der vier unterschiedlichen Proben in der Oszillationsfrequenz der Ausgangsspannung der Anordnung von LC-Oszillationen während der Änderung des statischen Magnetfeldes $B_0$ bestimmbar. Die Magnetfelder $B_0$ und $B_1$ müssen dabei den Resonanzbedingungen der Proben genügen.

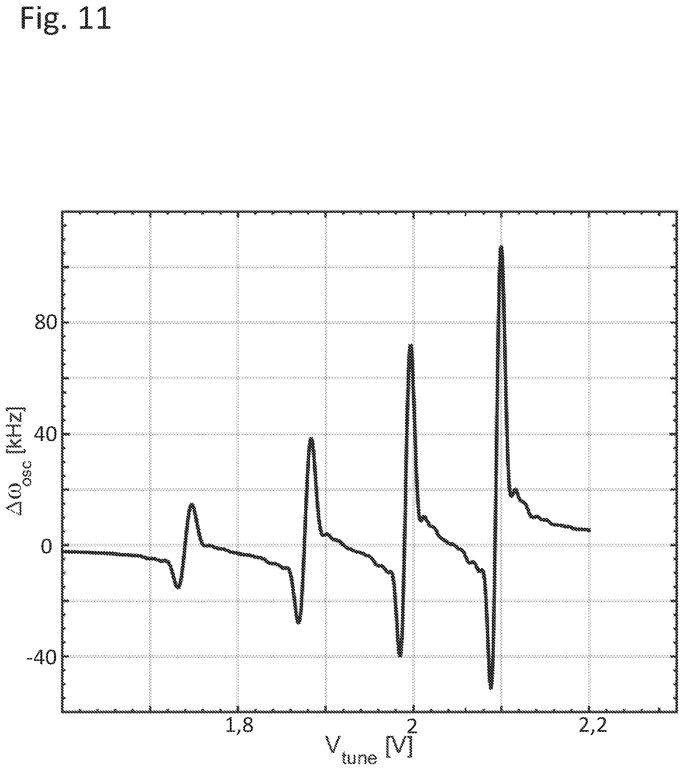

Eine Simulation der Änderung in der Oszillationsfrequenz einer Ausgangsspannung $\Delta\omega_{(osc,array)}$ einer Anordnung von vier frequenzsynchronisierten LC-Oszillatoren, gemäß der Fig. 5 und Fig. 6, ist ebenfalls in Fig. 11 gezeigt. Die Änderung wird von vier Proben mit jeweils unterschiedlichen $g$-Faktoren, die im Bereich der aktiven Fläche der Anordnung von LC-Oszillatoren angeordnet sind, während eines ESR-Experiments mit transientem Magnetfeld hervorgerufen. Der experimentelle Aufbau entspricht dabei dem in Fig. 8. Wie aus der Figur 11 ersichtlich, ist die jeweilige Änderung in der Magnetisierung der vier unterschiedlichen Proben während der Änderung der Steuerspannung, die ein transientes Magnetfeld in den LC-Oszillatoren auf Grundlage von geeigneten zeitabhängigen Wellenformen bewirkt, in der Oszillationsfrequenz der gesamten Anordnung bestimmbar. Die Magnetfelder $B_0$ und $B_1$ müssen dabei den Resonanzbedingungen der Proben genügen.

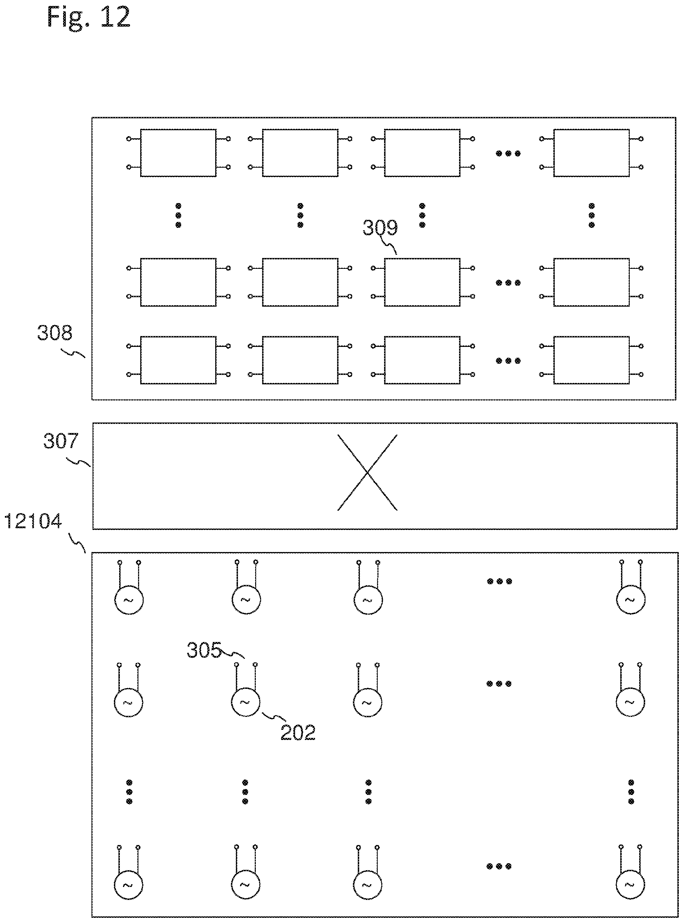

Ein Ausführungsbeispiel einer möglichen Verschaltung zur Frequenzsynchronisation der einzelnen LC-Oszillatoren **202** in einer flächenhaften Anordnung **12104** ist in Fig. 12 gezeigt. Hier wird der Ausgang **305** jedes einzelnen Oszillators **202** in den Ausgang eines anderen Oszillators **202** gespeist. Dies erfolgt durch ein Koppelnetzwerk, das gewährleistet, dass der Ausgang der einzelnen Oszillatoren **202** durch Netzwerkbereiche **309** in einzelne oder mehrere andere Oszillatoren **202** gespeist wird. Dabei ist **307** eine Verbindungsmatrix, die die $l \times k$ Oszillatorausgänge der Anordnung **12104** mit dem $l \times k$ Koppelnetzwerk **308** verbindet. Das Koppelnetzwerk **308** gewährleistet die Frequenzsynchronisation durch sogenanntes "Injection locking" (Verriegelung/Synchronisation durch Zufuhr/Injektion einer Frequenz), welches bewirkt, dass alle Oszillatoren **202** im Koppelnetzwerk **308** bei einer Frequenz $\omega_{(osc,array)}$ oszillieren.

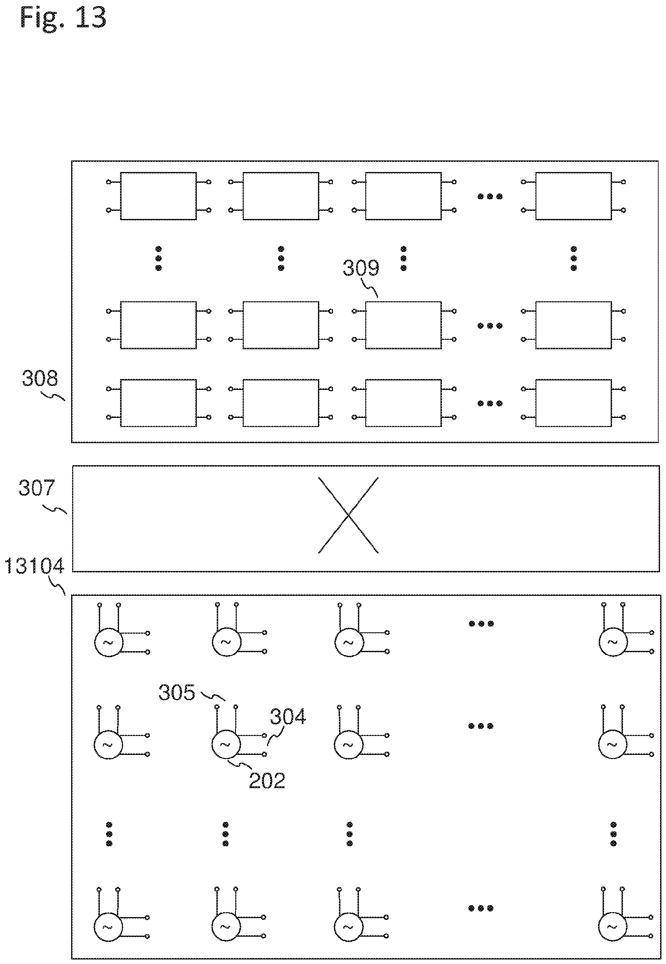

Ein weiteres Ausführungsbeispiel einer möglichen Verschaltung zur Frequenzsynchronisation der einzelnen LC-Oszillatoren **202** in einer flächenhaften Anordnung **13104** ist in Fig. 13 gezeigt. Hier weist jeder Oszillator **202** der Anordnung **13104** einen zusätzlichen Eingang **505** auf, in den das Ausgangssignal **504** eines oder mehrerer anderer Oszillatoren eingespeist wird. Die Verbindung zur Einspeisung erfolgt wechselseitig zwischen den einzelnen Oszillatoren und bewirkt eine gemeinsame Oszillationsfrequenz $\omega_{(osc,array)}$ der Anordnung **13104**. Eine Verbindungsmatrix **307** verbindet die $l \times k$ Oszillatorausgänge der Anordnung **13104** mit dem $l \times k$ Koppelnetzwerk **308** mit $l \times k$ Netzwerkbereichen **309**. Die Verbindung über die Verbindungsmatrix **307** zur Einspeisung erfolgt wechselseitig zwischen den einzelnen Oszillatoren und bewirkt eine gemeinsame Oszillationsfrequenz $\omega_{(osc,array)}$ der Anordnung **13104**.

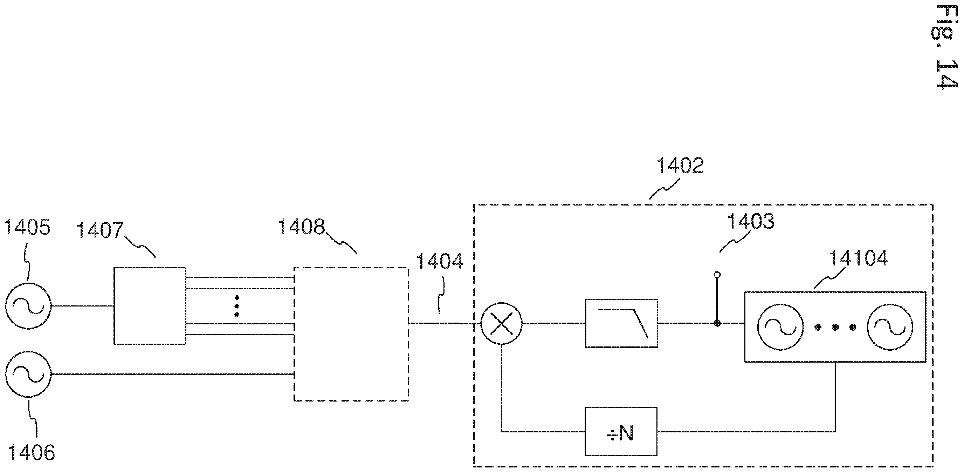

Eine erfindungsgemäße Anordnung von LC-Oszillatoren **14104**, eingebunden in eine Phasenregelschleife **1402,** ist in Fig. 14 gezeigt. Für die Verwirklichung der Phasenregelschleife muss zumindest einer der LC-Oszillatoren als spannungsgesteuerter Oszillator realisiert sein. Die Phasenregelschliefe **1402** garantiert, dass bei einer Folge von Anregungspulsen (transiente Magnetfelder) in einem ESR- oder NMR-Experiment die Phaseninformation aufeinanderfolgender Pulse nicht zwischen dem Schalten der Anordnung **14104** von LC-Oszillatoren zwischen einer anregenden Frequenz in der Nähe von oder gleich der Resonanzfrequenz und einer von dieser entfernten Frequenz verloren geht. Die Phasenkohärenz wird gewährleistet, indem eine Referenzfrequenz $\omega_{ref}$ **1404** aus zwei verschiedenen Quellen (Oszillatoren $\omega_{res}$ **1405**, $\omega_{off}$ **1406**) gewählt werden kann, die kontinuierlich bei einer Frequenz $\omega_{res}/N$ bzw. $\omega_{off}/N$ läuft, mit N = Teilungsfaktor der Phasenregelschleife **1402**, $\omega_{res}$ einer Frequenz in der Nähe von oder gleich der Resonanzfrequenz und $\omega_{off}$ einer von der Resonanzfrequenz entfernten Frequenz. Die Auswahl zwischen den beiden Frequenzen erfolgt mithilfe eines geeigneten Multiplexers **1407**. Wenn die Referenzfrequenz **1404** der Phasenregelschleife **1402** zwischen $\omega_{off}/N$ und $\omega_{res}/N$ geschaltet wird, wechselt die Frequenz der Anordnung **14104** von LC-Oszillatoren in der Phasenregelschleife **1402** durch die negative Rückführung in der Phasenregelschleife **1402** entsprechend zwischen $\omega_{off}$ und $\omega_{res}$. Da die Oszillatoren **1405/1406**, die als Quellen dienen, kontinuierlich bei den gleichen Frequenzen laufen, d.h. sie ändern diese nicht, ändert sich ihre Phase auch nicht zwischen zwei Zeitspannen, in denen ihre Frequenz in die Anordnung eingespeist wird, was besonders für die Zeitspannen für $\omega_{res}$ von Bedeutung ist. Da die Phasenregelschleife **1402** durch ihre negative Rückführstruktur die Phase der Anordnung **14104** mit der Phase des Referenzoszillators abgleicht, wird (unter Vernachlässigung von kurzen Einschwingvorgängen) gewährleistet, dass eine Folge von Anregungspulsen kohärent bzgl. ihrer Phase ist. Um darüber hinaus einen kohärenten Wechsel in Folgen von Anregungspulsen und verschiedenen Pulssequenzen (phase cycling) zu gewährleisten, kann die Schaltung gemäß der Fig. 14 erweitert werden mit zwei zusätzlichen Quellen für Referenzfrequenzen, die mit einem 90° Phasenunterschied zu den Quellen aus Fig. 14 laufen. So wird eine Anregung in der x'- und y'-Richtung des rotierenden Koordinatensystems (rotating frame of reference) ermöglicht. Die Schaltung kann außerdem erweitert werden, um Anregungen weiterer Richtungen zu ermöglichen, indem weitere Quellen für Referenzfrequenzen mit entsprechenden Phasenunterschieden hinzugefügt werden. Ein Ausgang **1403,** an dem direkt frequenzdemodulierte Signale abgreifbar sind, ist zusätzlich vorgesehen.


**Patentansprüche**

1. Vorrichtung zur Erzeugung und Detektion einer Magnetisierung einer Probe (103) mittels magnetischer Resonanz, mindestens aufweisend

   Mittel (101) zur

   Bereitstellung eines statischen Magnetfelds (102) vorbestimmter Richtung und Stärke an einem Probenort, eine Sendevorrichtung (104) zur Bereitstellung eines zusätzlichen Magnetfeldes am Probenort, eine Empfangsvorrichtung (104) zur Detektion einer Magnetisierung der Probe (103), wobei eine der Sende- oder Empfangsvorrichtung (104) aus einem LC-Oszillator (202), dessen Oszillationsfrequenz vom Wert eines induktiven Elements des LC-Oszillators abhängt, gebildet ist,

   Mittel zur Ansteuerung der Sendevorrichtung (104), wobei

   die Sendevorrichtung (104) und das Mittel zur Ansteuerung genügen, ein Magnetfeld zu erzeugen, das eine Magnetisierung der Probe (103) aus einer Gleichgewichtslage auszulenken vermag und, der Empfangsvorrichtung (104) nachgeschaltet,

   Mittel zur Demodulation (106), Analog-Digital-Umsetzer (710, 810, 811) sowie Mittel zur digitalen Datenverarbeitung (107), wobei Mittel zur Bestimmung der Magnetisierung der Probe (103) und die daraus zu ermittelnde Spinkonzentration einzelner Spektralkomponenten und Mittel zur Ausgabe der Magnetisierung auf dem Mittel zur digitalen Datenverarbeitung (107) bereitgestellt sind, und wobei der Probenort im Nahfeld der Sendevorrichtung (104), in dem noch keine Welle vorliegt, liegt,

   **dadurch gekennzeichnet, dass**

   • eine Anordnung (104) von mindestens zwei LC-Oszillatoren (202), deren Oszillationsfrequenz vom Wert eines induktiven Elements der LC-Oszillatoren (202) abhängt und die über eine Verschaltung, die als Koppelnetzwerk (308) ausgeführt ist, frequenzsynchronisiert sind und durch eine Steuerspannung erzwungen die gleiche Oszillationsfrequenz aufweisen sowohl die Empfangsvorrichtung (104) als auch die Sendevorrichtung (104) bildet, sowie auch simultan als Sende- und Empfangsvorrichtung nutzbar ist, und

   • einer der LC-Oszillatoren der Anordnung (104) als spannungsgesteuerter Oszillator ausgeführt ist und die Vorrichtung in eine Phasenregelschleife (1402) eingebunden ist, so dass alle LC-Oszillatoren in der Anordnung (104) einer Referenzfrequenz folgen.

2. Vorrichtung nach Anspruch 1,
   **dadurch gekennzeichnet, dass**

das Koppelnetzwerk ausgeführt ist, indem jeder LC-Oszillator (202) über einen zusätzlichen Eingang (505) verfügt, und eine Ausgangsspannung mindestens eines weiteren LC-Oszillators in den zusätzlichen Eingang eingespeist ist, und wobei die LC-Oszillatoren (202) mindestens jeweils zweiseitig miteinander verschaltet sind.

3. Vorrichtung nach einem der vorhergehenden Ansprüche,
**dadurch gekennzeichnet, dass**
die LC-Oszillatoren als LC-VCOs ausgeführt sind.

4. Vorrichtung nach einem der vorhergehenden Ansprüche,
**dadurch gekennzeichnet, dass**

• die Anordnung (104) und das Mittel zur Ansteuerung genügen, ein transientes Magnetfeld zu erzeugen, das eine Magnetisierung der Probe (103) aus einer Gleichgewichtslage auszulenken vermag und
• die Mittel zur Bestimmung der Magnetisierung der Probe (103) und die daraus zu ermittelnde Spinkonzentration einzelner Spektralkomponenten anhand einer Frequenz und/oder Amplitude der Ausgangsspannung der Anordnung (104) auf Grundlage eines physikalischen Modells transienter Induktivität und transienten Widerstands einer Spule basieren.

5. Vorrichtung nach Anspruch 4,
**dadurch gekennzeichnet, dass**
das Mittel zur Demodulation (106) ein Frequenzdemodulator ist und die Mittel zur Bestimmung der Magnetisierung der Probe (103) und die daraus zu ermittelnde Spinkonzentration einzelner Spektralkomponenten anhand einer Frequenz der Ausgangsspannung der Anordnung (104) auf Grundlage des physikalischen Modells transienter Induktivität und transienten Widerstands einer Spule einen Term entsprechend

$$\omega_{osc} = \frac{1}{\sqrt{L_0 \cdot C}} - \frac{1}{2} \cdot \frac{1}{(L_0 \cdot C)^{\frac{3}{2}}} \cdot C \cdot \Delta L_{sample},$$

mit $\omega_{osc}$ = Frequenz eines LC-Oszillators, $C$ = Kapazität der Spule, $L_0$ = probenunabhängige Induktivität der Spule, $\Delta L_{sample}$ = probenabhängige Änderung der Induktivität der Spule umfasst.

6. Vorrichtung nach Anspruch 4,
**dadurch gekennzeichnet, dass**
ein Mittel zur Demodulation ein Amplitudendemodulator ist und die Mittel zur Bestimmung der Magnetisierung der Probe (103) und die daraus zu ermittelnde Spinkonzentration einzelner Spektralkomponenten anhand einer Amplitude der Ausgangsspannung der Anordnung (104) auf Grundlage des physikalischen Modells transienter Induktivität und transienten Widerstands einer Spule einen Term entsprechend

$$A_{osc} = A_{osc}\big|_{R_{eff}=R_0} + \frac{\partial A_{osc}}{\partial R_{eff}}\bigg|_{R_{eff}=R_0} \cdot R_{sample,tot}$$

umfasst, *mit* $A_{osc}$ = Oszillationsamplitude eines LC-Oszillators, $R_{eff}$ = effektiver Widerstand der Spule, $R_0$ = ohmscher Spulenwiderstand und $R_{sample,tot}$ = durch die Probe induzierter Widerstand der Spule.

7. Vorrichtung nach Anspruch 5 und 6,
**dadurch gekennzeichnet, dass**
als Mittel zur Demodulation ein Frequenzdemodulator und ein Amplitudendemodulator angeordnet ist und die Mittel zur Bestimmung der Magnetisierung der Probe (103) und die daraus zu ermittelnde Spinkonzentration einzelner Spektralkomponenten anhand mindestens einer Frequenz und Amplitude der Ausgangsspannung der Anordnung (104) auf Grundlage des physikalischen Modells transienter Induktivität und transienten Widerstands einer Spule Terme entsprechend

$$\omega_{osc} = \frac{1}{\sqrt{L_0 \cdot C}} - \frac{1}{2} \cdot \frac{1}{(L_0 \cdot C)^{\frac{3}{2}}} \cdot \Delta L_{sample}$$

und

$$A_{osc} = A_{osc} \Big|_{R_{eff}=R_0} + \frac{\partial A_{osc}}{\partial R_{eff}} \Big|_{R_{eff}=R_0} \cdot R_{sample,tot}$$

umfasst.

**Claims**

1. Device for the generation and detection of magnetisation of a sample (103) by means of magnetic resonance at least comprising means (101) for providing a static magnetic field (102) of predetermined direction and strength at a sample location, an emitting device (104) for providing an additional magnetic field at the sample location, a receiving device (104) for detecting magnetisation of the sample (103) wherein the emitting or receiving device (104) is formed by an LC oscillator (202), the oscillation frequency of which depends on the value of an inductive element of the LC oscillator, means for controlling the emitting device (104), wherein the emitting device (104) and the means for controlling are sufficient for producing a magnetic field which can deflect magnetisation of the sample (103) from a state of equilibrium and, downstream of the receiving device (104), demodulation means (106), analogue-digital converters (710, 810, 811) as well as means for digital data processing (107), wherein means for determining the magnetisation of the sample (103) and the thereby to be determined spin concentration of individual spectral components and means for outputting the magnetisation to the means for digital data processing (107) are provided, and wherein the sample location is in the near field of the emitting device (104) in which no wave is yet present, **characterised in that**

   • an arrangement (104) of at least two LC oscillators (202), the oscillation frequency of which depends on the value of an inductive element of the LC oscillators (202) and which, via an interconnection configured as a coupling network (308), are frequency-synchronised and through a control voltage have the same enforced oscillation frequency, forms both the receiving device (104) and also the emitting device (104), as well as simultaneously being usable as an emitting and receiving device, and
   • one of the LC oscillators of the arrangement (104) is designed as a voltage-controlled oscillator and the device is incorporated into a phase locked loop (1402) so that all LC oscillators in the arrangement (104) follow a reference frequency.

2. Device according to claim 1
   **characterised in that**
   the coupling network is configured in such a way that each LC oscillator (202) has an additional input (505) and an output voltage of at least one further LC oscillator is fed into the additional input, and wherein the LC oscillators (202) are each at least bilaterally connected to each other.

3. Device according to any one of the preceding claims
   **characterised in that**
   the LC oscillators are designed as LC-VCOs.

4. Device according to any one of the preceding claims
   **characterised in that**

   • the device (104) and the means for controlling are sufficient to generate a transient magnetic field which is able to deflect magnetisation of the sample (103) from a stage of equilibrium and
   • the means for determining the magnetisation of the sample (103) and the thereby to be determined spin concentration of individual spectral components by way of a frequency and/or amplitude of the output voltage of the device (104) are based on a physical model of transient inductivity and transient resistance of a coil.

5. Device according to claim 4
   **characterised in that**
   the demodulation means (106) is a frequency modulator and the means for determining the magnetisation of a sample (103) and the thereby to be determined spin concentration of individual spectral components by way of a frequency of the output voltage of the device (104) on the basis of the physical model of transient inductivity and transient resistance of a coil comprises a term corresponding to

$$\omega_{osc} = \frac{1}{\sqrt{L_0 \cdot C}} - \frac{1}{2} \cdot \frac{1}{(L_0 \cdot C)^{\frac{3}{2}}} \cdot C \cdot \Delta L_{sample},$$

where $\omega_{osc}$ = frequency of an LC oscillator, $C$ = capacitance of the coil, $L_0$ = sample-independent inductivity of the coil, $\Delta L_{sample}$ = sample-dependent change in the inductivity of the coil.

6. Device according to claim 4
   **characterised in that**
   a demodulation means is an amplitude demodulator and the means for determining the magnetisation of the sample (103) and the thereby to be determined spin concentration of individual spectral components by way of an amplitude of the output voltage of the device (104) on the basis of the physical model of transient inductivity and transient resistance of a coil comprises a term corresponding to

$$A_{osc} = A_{osc}\Big|_{R_{eff}=R_0} + \frac{\partial A_{osc}}{\partial R_{eff}}\Big|_{R_{eff}=R_0} \cdot R_{sample,tot}$$

where $A_{osc}$ = oscillation amplitude of an LC oscillator, $R_{eff}$ = effective resistance of the coil, $R_0$ = ohmic resistance and $R_{sample,\,tot}$ = resistance of the coil inducted by the sample.

7. Device according to claim 5 and 6
   **characterised in that**
   as demodulation means a frequency demodulator and an amplitude demodulator is provided and the means for determining the magnetisation of the sample (103) and the thereby to be determined spin concentration of individual spectral components by way of a frequency and amplitude of the output voltage of the device (104) on the basis of the physical model of transient inductivity and transient resistance of a coil comprises terms corresponding to

$$\omega_{osc} = \frac{1}{\sqrt{L_0 \cdot C}} - \frac{1}{2} \cdot \frac{1}{(L_0 \cdot C)^{\frac{3}{2}}} \cdot \Delta L_{sample}$$

and

$$A_{osc} = A_{osc}\Big|_{R_{eff}=R_0} + \frac{\partial A_{osc}}{\partial R_{eff}}\Big|_{R_{eff}=R_0} \cdot R_{sample,tot}$$ .

## Revendications

1. Dispositif, destiné à générer et à détecter une magnétisation d'une éprouvette (103) au moyen d'une résonance magnétique, comportant au moins des moyens (101) destinés à mettre à disposition un champ magnétique (102) statique, de direction et d'intensité prédéfinies sur un emplacement de l'éprouvette, un dispositif émetteur (104), destiné à mettre à disposition un champ magnétique additionnel sur l'emplacement de l'éprouvette, un dispositif récepteur (104) destiné à détecter une magnétisation de l'éprouvette (103), l'un du dispositif émetteur ou dispositif récepteur (104) étant formé d'un oscillateur LC (202), dont la fréquence d'oscillation dépend de la valeur d'un élément inductif de l'oscillateur LC, , des moyens d'activation du dispositif émetteur (104), le dispositif émetteur (104) et le moyen d'activation suffisant à générer un champ magnétique qui est susceptible de dévier une magnétisation de l'éprouvette (103) hors d'une position d'équilibre et qui est monté en aval du dispositif récepteur (104), des moyens de démodulation (106), des convertisseurs analogique/numérique (710, 810, 811) ainsi que des moyens de traitement numérique de données (107), des moyens de détermination de la magnétisation de l'éprouvette (103) et la concentration de crête qui doit être identifiée à partir de ceux-ci de composantes spectrales individuelles et des moyens d'édition de la magnétisation sur le moyen de traitement numérique des données (107) étant mis à disposition, et l'emplacement de l'éprouvette se situant dans le champ proche du dispositif émetteur (104), dans lequel aucune onde n'est encore présente,

**caractérisé en ce**

• **qu'**un agencement (104) d'au moins deux oscillateurs LC (202), dont la fréquence d'oscillation dépend de la valeur d'un élément inductif des oscillateurs LC (202) et qui par l'intermédiaire d'un câblage qui est réalisé sous la forme d'un réseau de couplage (308) sont synchronisés en fréquence et forcés par une tension de commande, présentent la même fréquence d'oscillation forme aussi bien le dispositif récepteur (104) qu'également le dispositif émetteur (104) et est simultanément utilisable en tant que dispositif émetteur et récepteur et
• **que** l'un des oscillateurs LC de l'agencement (104) est réalisé sous la forme d'un oscillateur commandé en tension et le dispositif est intégré dans une boucle à phase asservie (1402), de sorte que tous les oscillateurs LC dans l'agencement (104) suivent une fréquence de référence.

2. Dispositif selon la revendication 1, **caractérisé en ce que** le réseau de couplage est réalisé **en ce que** chaque oscillateur LC (202) dispose d'une entrée additionnelle (505) et **en ce qu'**une tension de sortie d'au moins un autre oscillateur LC est alimentée dans l'entrée additionnelle, et les oscillateurs LC (202) étant au moins câblés les uns aux autres chacun sur deux côtés.

3. Dispositif selon l'une quelconque des revendications précédentes, **caractérisé en ce que** les oscillateurs LC sont réalisés sous la forme de LC-VCO.

4. Dispositif selon l'une quelconque des revendications précédentes, **caractérisé en ce que**

• l'agencement (104) et le moyen d'activation suffisent à générer un champ magnétique transitoire qui est susceptible de dévier une magnétisation de l'éprouvette (103) hors d'une position d'équilibre et
• les moyens de détermination de la magnétisation de l'éprouvette (103), la concentration de crête qui doit être identifiée à partir de ceux-ci de composantes spectrales individuelles à l'aide d'une fréquence et/ou d'une amplitude de la tension de sortie de l'agencement (104) sont basés sur un modèle physique d'inductance transitoire et de résistance transitoire.

5. Dispositif selon la revendication 4, **caractérisé en ce que** le moyen de démodulation (106) est un modulateur de fréquence et comprend les moyens de détermination de la magnétisation de l'éprouvette (103) et la concentration de crête qui doit être identifiée à partir de ceux-ci de composantes spectrales individuelles à l'aide d'une fréquence de la tension de sortie de l'agencement (104) sur la base du modèle physique d'inductance transitoire et de résistance transitoire d'une bobine selon un terme correspondant à

$$\omega_{osc} = \frac{1}{\sqrt{L_0 \cdot C}} - \frac{1}{2} \cdot \frac{1}{(L_0 \cdot C)^{\frac{3}{2}}} \cdot C \cdot \Delta L_{sample},$$

avec $\omega_{osc}$ = fréquence d'un oscillateur LCs, C = capacité de la bobine, $L_0$ = inductance de la bobine indépendante de l'éprouvette, $\Delta L_{sample}$ = variation dépendant de l'éprouvette de l'inductance de la bobine.

6. Dispositif selon la revendication 4,
**caractérisé en ce qu'**un moyen de démodulation est un modulateur d'amplitude et comprend les moyens de détermination de la magnétisation de l'éprouvette (103) et la concentration de crête qui doit être identifiée à partir de ceux-ci de composantes spectrales individuelles à l'aide d'une amplitude de la tension de sortie de l'agencement (104) sur la base du modèle physique d'inductance transitoire et de résistance transitoire d'une bobine selon un terme correspondant à

$$A_{osc} = A_{osc} \Big|_{R_{eff}=R_0} + \frac{\partial A_{osc}}{\partial R_{eff}} \Big|_{R_{eff}=R_0} \cdot R_{sample,tot}$$

avec $A_{osc}$ = amplitude d'oscillation d'un oscillateur LC, $R_{eff}$ = résistance effective de la bobine, $R_0$ = résistance ohmique de la bobine et $R_{sample,tot}$ = résistance de la bobine induite par l'éprouvette.

7. Dispositif selon la revendication 5 et 6,
**caractérisé en ce qu'**en tant que moyen de démodulation est placé un modulateur de fréquence et un modulateur d'amplitude et **en ce qu'**il comprend les moyens de détermination de la magnétisation de l'éprouvette (103) et la concentration de crête qui doit être identifiée à partir de ceux-ci de composantes spectrales individuelles à l'aide d'au moins une fréquence et une amplitude de la tension de sortie de l'agencement (104) sur la base du modèle physique d'inductance transitoire et de résistance transitoire d'une bobine selon des termes correspondant à

$$\omega_{osc} = \frac{1}{\sqrt{L_0 \cdot C}} - \frac{1}{2} \cdot \frac{1}{(L_0 \cdot C)^{\frac{3}{2}}} \cdot \Delta L_{sample}$$

et

$$A_{osc} = A_{osc}\big|_{R_{eff}=R_0} + \frac{\partial A_{osc}}{\partial R_{eff}}\big|_{R_{eff}=R_0} \cdot R_{sample,tot} \quad .$$

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4223909 C2
- DE 4412064 A1
- US 20140210473 A1
- DE 102015120644

**In der Beschreibung aufgeführte Nicht-Patentliteratur**

- **M. PRISNER et al.** Pulsed EPR Spectroscopy: Biological Applications. *Annual Review of Physical Chemistry,* 2001, vol. 52, 279-313
- **R. BENN ; H. GÜNTHER.** Modern Pulse Methods in High-Resolution NMR Spectroscopy. *Angewandte Chemie International Edition,* 1983, vol. 22, 350-380
- **T. YALCIN ; G. BOERO.** Single-chip detector for electron spin resonance spectroscopy. *Review of Scientific Instruments,* 2008, vol. 79, 094105-1, 6
- **N. BLOEMBERGEN ; R.V. POUND.** Radiation Damping in Magnetic Resonance Experiments. *Physical Reviews,* 1954, vol. 95 (1), 8-12
- **J. ANDERS et al.** A single-chip array of NMR receivers. *Journal of Magnetic Resonance,* 2009, vol. 201, 239-249
- **P. KINGET.** Amplitude detection inside CMOS LC oscillators, 2006 IEEE International Symposium on Circuits and Systems. *Proceedings,* 2006, vol. 1-11, 5147-5150